# EUROPEAN PATENT APPLICATION

(11) **EP 4 064 355 A1**
(43) Date of publication of application: **28.09.2022**
(21) Application number: 22161675.8
(22) Date of filing: 11.03.2022
(51) Int. Cl.: H01L 27/30, H01L 51/42

(54) **SOLAR CELL MODULE**

(30) Priority: 23.03.2021 JP 2021048846; 08.03.2022 JP 2022035341
(71) Applicant: Ricoh Company, Ltd., Tokyo 143-8555 (JP)
(72) Inventor: HORIUCHI, Tamotsu, Tokyo, 143-8555 (JP); TAMOTO, Nozomu, Tokyo, 143-8555 (JP); TANAKA, Yuuji, Tokyo, 143-8555 (JP); KANEI, Naomichi, Tokyo, 143-8555 (JP); IDE, Takahiro, Tokyo, 143-8555 (JP)
(74) Representative: Marks & Clerk LLP

(57) **Abstract**

Provided is a solar cell module 100 including a substrate 1, and a plurality of photoelectric conversion elements 11a, 11b provided on the substrate and each including a first electrode 2, an electron transporting layer 4, a perovskite layer 5, a hole transporting layer 6, and a second electrode 7. In adjoining two of the photoelectric conversion elements 11a, 11b, the first electrodes 2 are electrically coupled to each other, and the electron transporting layers 4, the perovskite layers 5, and the hole transporting layers 6 are each separated from each other by a gap. The second electrode 7 of one of the photoelectric conversion elements 11a and the first electrode 2 of the other of the photoelectric conversion elements 11b are electrically coupled to each other. The first electrode 2, the electron transporting layer 4, and the perovskite layer 5 in the one of the photoelectric conversion elements 11a, 11b are divided by the hole transporting layer 6.

## Description

### BACKGROUND OF THE INVENTION

### Field of the Invention

The present disclosure relates to a solar cell module.

### Description of the Related Art

In recent years, solar cells utilizing photoelectric conversion elements have been expected to be applied to a wide range of fields not only as an alternative to fossil fuels or a measure for global warming, but also as stand-alone power supplies that need no battery exchange or power supply wiring. Solar cells as stand-alone power supplies have also been paid much attention as one of energy harvesting technologies needed in Internet of Things (IoT) devices and artificial satellites.

Solar cells include hitherto-widely-used inorganic solar cells using, for example, silicon, and organic solar cells such as dye-sensitized solar cells, organic thin-film solar cells, and perovskite solar cells. Perovskite solar cells can be produced by existing printing methods without using electrolytic solutions containing, for example, iodine and organic solvents. Therefore, perovskite solar cells are advantageous in terms of, for example, safety enhancement and production cost saving.

Regarding organic thin-film solar cells and perovskite solar cells, it is known to electrically couple a plurality of spatially divided photoelectric conversion elements as a serial circuit, in order to output a high voltage (for example, see Japanese Unexamined Patent Application Publication No. 2016-195175).

### SUMMARY OF THE INVENTION

The present disclosure has an object to provide a solar cell module that can maintain a power generation efficiency even through exposure to high-illuminance light for a long time.

According to one aspect of the present disclosure, a solar cell module includes a substrate, and a plurality of photoelectric conversion elements provided on the substrate and each including a first electrode, an electron transporting layer, a perovskite layer, a hole transporting layer, and a second electrode. In adjoining two of the photoelectric conversion elements, the first electrodes are electrically coupled to each other, and the electron transporting layers, the perovskite layers, and the hole transporting layers are each separated from each other by a gap. The second electrode of one of the photoelectric conversion elements and the first electrode of the other of the photoelectric conversion elements are electrically coupled to each other. The first electrode, the electron transporting layer, and the perovskite layer in the one of the photoelectric conversion elements are divided by the hole transporting layer.

The present disclosure can provide a photoelectric conversion module that can maintain a power generation efficiency even through exposure to high-illuminance light for a long time.

### BRIEF DESCRIPTION OF THE DRAWINGS

FIG. 1 is a schematic view illustrating an example of a cross-sectional structure of a device in the middle of being produced in Example 1;
FIG. 2 is a schematic view illustrating an example of a cross-sectional structure of a device in the middle of being produced in Example 1;
FIG. 3 is a schematic view illustrating an example of a cross-sectional structure of a device in the middle of being produced in Example 1;
FIG. 4 is a schematic view illustrating an example of a cross-sectional structure of a device in the middle of being produced in Example 1;
FIG. 5 is a schematic view illustrating an example of a top view of a device in the middle of being produced in Example 1;
FIG. 6 is a schematic view illustrating an example of a cross-sectional structure of a device in the middle of being produced in Example 1;
FIG. 7 is a schematic view illustrating an example of a cross-sectional structure of a device in the middle of being produced in Example 1;
FIG. 8 is a schematic view illustrating an example of a top view of a device in the middle of being produced in Example 1;
FIG. 9 is a schematic view illustrating an example of a cross-sectional structure of a device in the middle of being produced in Example 1; and
FIG. 10 is a schematic view illustrating an example of cross-sectional structures of devices produced in Examples 1 and 4.

### DESCRIPTION OF THE EMBODIMENTS

### (Solar cell module)

A solar cell module of the present disclosure represents a device that can convert light energy to electric energy, or can covert electric energy to light energy. A solar cell module is applied to, for example, solar cells and photodiodes.

In adjoining two photoelectric conversion elements of the solar cell module of the present disclosure, the first electrodes are electrically coupled to each other, and the electron transporting layers, the perovskite layers, and the hole transporting layers are each separated from each other by a gap. The second electrode of one of the photoelectric conversion elements and the first electrode of the other of the photoelectric conversion elements are electrically coupled to each other. The first electrode, the electron transporting layer, and the perovskite layer in the one of the photoelectric conversion elements are divided by the hole transporting layer.

The solar cell module of the present disclosure includes a plurality of photoelectric conversion elements on the substrate, preferably further includes a second substrate different from the substrate described above ad a sealing member, and further includes other members as needed.

The present disclosure is based on a finding that existing solar cell modules may undergo a significant power generation efficiency degradation through exposure to high-illuminance light for a long time. Specifically, existing solar cell modules, in which a porous titanium oxide layer and a perovskite layer are provided in an extending manner, have many chances of electron recombination due to diffusion, and hence have a problem that the power generation efficiency of the solar cell modules significantly degrades through exposure to high-illuminance light for a long time.

On the other hand, in the solar cell module of the present disclosure, the first electrodes, the electron transporting layers, and the perovskite layers are separated by the hole transporting layers in at least two photoelectric conversion elements separated from each other via a gap. As a result, the solar cell module of the present disclosure has discontinuous perovskite layers and fewer chances of electron recombination due to diffusion, and can maintain the power generation efficiency even through exposure to high-illuminance light for a long time.

Another problem is that the hole transporting layer and the second electrode, which have a low adhesiveness with each other, are easily peeled from each other.

### <Substrate>

The shape, structure, and size of the substrate are not particularly limited and may be appropriately selected depending on the intended purpose. In the following description, the substrate described above may be referred to as first substrate.

The material of the first substrate is not particularly limited and may be appropriately selected depending on the intended purpose so long as the material has translucency and an insulating property. Examples of the material of the first substrate include glass, plastic films, and ceramic. Among these materials, a material having heat resistance at a burning temperature is preferable when a burning step is included during formation of an electron transporting layer as described below. It is preferable that the first substrate have flexibility.

### <First electrode>

The structure of the first electrode is not particularly limited and may be appropriately selected depending on the intended purpose. The first electrode may have a single-layer structure or a laminate structure in which a plurality of materials are laminated.

In the photoelectric conversion elements, the first electrodes are separated by the hole transporting layers. This makes it possible to prevent electron diffusion.

Here, the first electrodes separated by the hole transporting layers represent first electrodes formed by a first electrode being divided into at least two by the hole transporting layer. One of the first electrodes and the other of the first electrodes are not continuous from each other, and have the hole transporting layer in between,

The material of the first electrode is not particularly limited and may be appropriately selected depending on the intended purpose so long as the material has conductivity. Examples of the material of the first electrode include transparent conductive metal oxides, carbon, and metals.

Examples of the transparent conductive metal oxides include indium tin oxide (hereinafter referred to as "ITO"), fluorine-doped tin oxide (hereinafter referred to as "FTO"), antimony-doped tin oxide (hereinafter referred to as "ATO"), niobium-doped tin oxide (hereinafter referred to as "NTO"), aluminum-doped zinc oxide, indium zinc oxide, and niobium titanium oxide.

Examples of carbon include carbon black, carbon nanotube, graphene, and fullerene.

Examples of the metals include gold, silver, aluminum, nickel, indium, tantalum, and titanium.

One of these materials may be used alone or two or more of these materials may be used in combination. Among these materials, transparent conductive metal oxides having a high transparency are preferable, and ITO, FTO, ATO, and NTO are more preferable.

The average thickness of the first electrode is not particularly limited, may be appropriately selected depending on the intended purpose, and is preferably 5 nm or greater but 100 micrometers or less and more preferably 50 nm or greater but 10 micrometers or less. When the material of the first electrode is carbon or a metal, it is preferable that the first electrode have an average thickness through which translucency can be obtained.

The first electrode can be formed by a known method such as a sputtering method, a vapor deposition method, and a spray method.

It is preferable that the first electrode be formed on a substrate. A commercially available integrated product in which the first electrode is previously formed on a substrate may be used.

Examples of the commercially available integrated product include FTO-coated glass, ITO-coated glass, zinc oxide, aluminum-coated glass, FTO-coated transparent plastic films, and ITO-coated transparent plastic films. Other examples of the commercially available integrated product include a transparent electrode of tin oxide or indium oxide doped with a cation or an anion having a different valence, and a glass substrate provided with a metal electrode shaped into a structure through which light can be transmitted, such as a meshed shape and a striped shape.

One of these products may be used alone, or two or more of these products may be used in combination and mixed or laminated. In order to reduce the electric resistance value, a metal lead wire may be used in combination In order to produce the solar cell module described below, the electrode included in the commercially available integrated product may be appropriately machined in a manner that the substrate on which a plurality of first electrodes are formed is produced.

Examples of the material of the metal lead wire include aluminum, copper, silver, gold, platinum, and nickel.

For use in combination, the metal lead wire may be formed on the substrate by, for example, vapor deposition, sputtering, and crimping, and an ITO or FTO layer may be formed thereon. Alternatively, the metal lead wire may be formed on ITO or FTO.

### <Electron transporting layer>

An electron transporting layer represents a layer that transports electrons produced in the perovskite layer described below to the first electrode. Therefore, it is preferable that the electron transporting layer be disposed in a manner to adjoin the first electrode.

In the photoelectric conversion elements, the electron transporting layers are separated by the hole transporting layers, and are further separated by the second electrodes. As a result, electron diffusion can be prevented.

The shape and size of the electron transporting layer are not particularly limited and may be appropriately selected depending on the intended purpose.

The structure of the electron transporting layer is not particularly limited and may be appropriately selected depending on the intended purpose. For example, the electron transporting layer may have a single-layer structure or a multi-layer structure in which a plurality of layers are laminated. Of these structures, a multi-layer structure is preferable, and a multi-layer structure formed of a layer having a dense structure (hereinafter, may be referred to as a dense layer) and a layer having a porous structure (hereinafter, may be referred to as a porous layer) is more preferable. It is preferable that the dense layer be closer to the first electrode than the porous layer is to the first electrode.

The dense layer contains an electron transporting material.

The electron transporting material is not particularly limited and may be appropriately selected depending on the intended purpose. Examples of the electron transporting material include semiconductor materials.

The semiconductor materials are not particularly limited and known materials may be used. Examples of the semiconductor materials include element semiconductors, and compounds containing compound semiconductors.

Examples of the element semiconductors include silicon and germanium.

Examples of the compound semiconductors include metal chalcogenides.

Examples of the metal chalcogenides include metal oxides (oxide semiconductors), metal sulfides, metal selenides, and metal tellurides.

Examples of the metal oxides (oxide semiconductors) include oxides of, for example, titanium, tin, zinc, iron, tungsten, zirconium, hafnium, strontium, indium, cerium, yttrium, lanthanum, vanadium, niobium, and tantalum.

Examples of the metal sulfides include sulfides of, for example, cadmium, zinc, lead, silver, antimony, and bismuth.

Examples of the metal selenides include selenides of, for example, cadmium and lead.

Examples of the metal tellurides include tellurides of, for example, cadmium.

Examples of other compound semiconductors include phosphides of, for example, zinc, gallium, indium, and cadmium, gallium arsenic, copper-indium selenide, and copper-indium sulfide.

Among these semiconductor materials, metal oxides (oxide semiconductors) are preferable. It is more preferable that the electron transporting layer contain at least one selected from titanium oxides, zinc oxides, tin oxides, and niobium oxides. It is particularly preferable that the electron transporting layer contain tin oxide.

One of these semiconductor materials may be used alone or two or more of these semiconductor materials may be used in combination. The crystal type of the semiconductor material is not particularly limited, may be appropriately selected depending on the intended purpose, and may be monocrystalline, polycrystalline, or amorphous.

It is preferable that the dense layer contain at least one compound selected from phosphonic acid compounds, boronic acid compounds, sulfonic acid compounds, halogenated silyl compounds, and alkoxy silyl compounds on the electron transporting material on a surface of the dense layer at the perovskite layer side. The dense layer containing such a compound on the electron transporting material on the surface of the dense layer at the perovskite layer side is expected to have controlled interfacial properties. In other words, the compound coating the electron transporting material on the surface of the dense layer at the perovskite layer side is expected to reduce the interface resistance and make electron migration smooth.

The compound may be bonded with the electron transporting material. Examples of bonding include covalent bonding and ionic bonding.

The compound is at least one selected from phosphonic acid compounds, boronic acid compounds, sulfonic acid compounds, halogenated silyl compounds, and alkoxy silyl compounds.

It is preferable that the compound contain a nitrogen atom in terms of compatibility with the perovskite layer.

The phosphonic acid compound is not particularly limited and may be appropriately selected depending on the intended purpose so long as the phosphonic acid compound contains a phosphonic acid group. Specific examples of the phosphonic acid compound are presented below.

The boronic acid compound is not particularly limited and may be appropriately selected depending on the intended purpose so long as the boronic acid compound contains a boronic acid group. Specific examples of the boronic acid compounds are presented below.

The sulfonic acid compound is not particularly limited and may be appropriately selected depending on the intended purpose so long as the sulfonic acid compound contains a sulfonic acid group. Specific examples of the sulfonic acid compound are presented below.

The halogenated silyl compound is not particularly limited and may be appropriately selected depending on the intended purpose so long as the halogenated silyl compound contains a halogenated silyl group. Specific examples of the halogenated silyl compound are presented below.

The alkoxy silyl compound is not particularly limited and may be appropriately selected depending on the intended purpose so long as the alkoxy silyl compound contains an alkoxy silyl group. Specific examples of the alkoxy silyl compound are presented below.

The molecular weight of the compound is not particularly limited, may be appropriately selected depending on the intended purpose, and is, for example, 100 or greater but 500 or less.

The compound is represented by, for example, General formula (4) below.

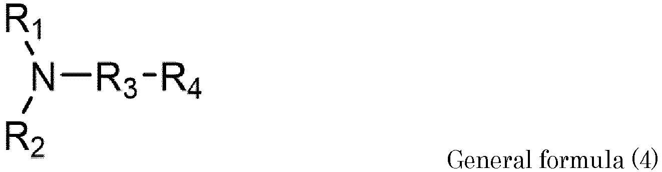

R3 represents a divalent aryl group or a divalent heterocycle, and R₄ represents a phosphonic acid group, a boronic acid group, a sulfonic acid group, a halogenated silyl group, or an alkoxy silyl group. R₁ or R₂, R₃, and N may form a cyclic structure together.

Examples of the compound include the following compounds.

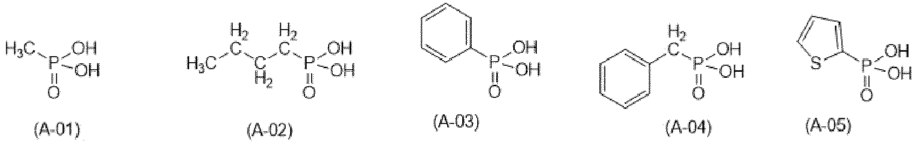

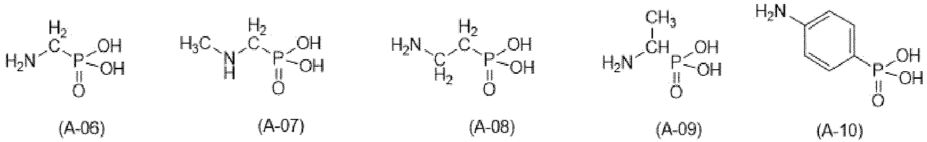

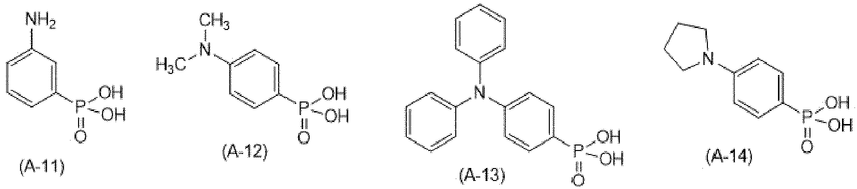

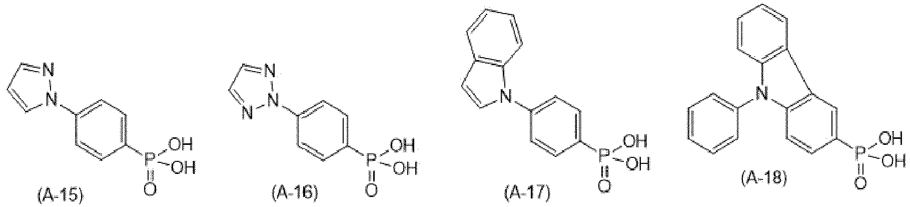

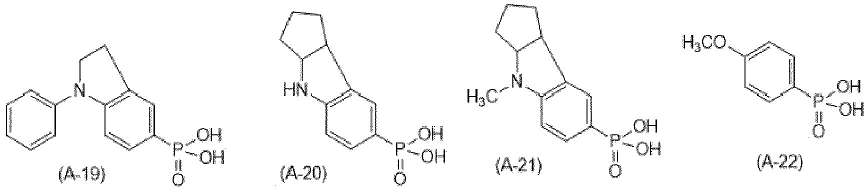

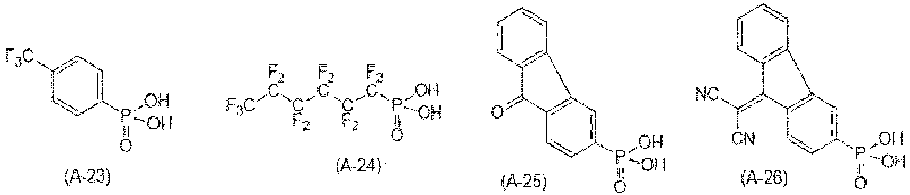

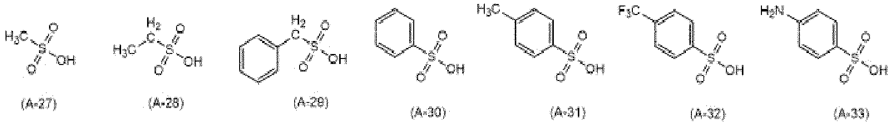

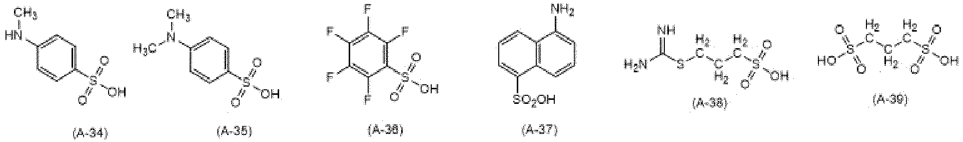

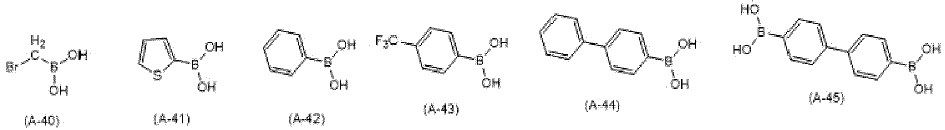

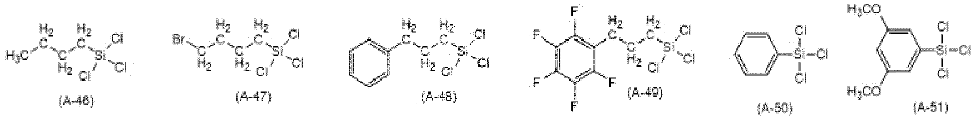

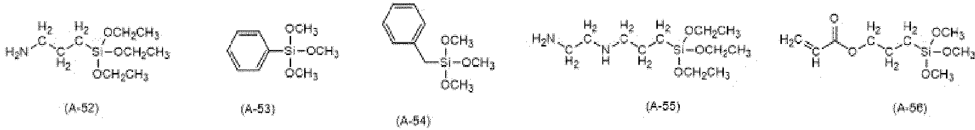

The film thickness of the dense layer is not particularly limited, may be appropriately selected depending on the intended purpose, and is preferably 5 nm or greater but 1 micrometer or less and more preferably 10 nm or greater but 700 nm or less.

It is preferable that the surface of the dense layer at the perovskite layer side be smooth as much as possible. A roughness factor, which is one indicator of smoothness, is preferably low as much as possible. However, in relation with the average thickness of the dense layer, the roughness factor of the dense layer at the perovskite layer side is preferably 20 or less and more preferably 10 or less. The lower limit of the roughness factor is not particularly limited, may be appropriately selected depending on the intended purpose, and is, for example, 1 or greater.

The roughness factor is a ratio of an actual surface area to an apparent surface area, and is also referred to as Wenzel's roughness factor. The actual surface area can be measured by measurement of, for example, BET specific surface area. When the measured value is divided by the apparent surface area, the roughness factor can be obtained.

The method for producing the dense layer is not particularly limited and may be appropriately selected depending on the intended purpose. Examples of the method include a method of forming a thin film of the electron transporting material in a vacuum (vacuum film formation method), and a wet film formation method.

Examples of the vacuum film formation method include a sputtering method, a pulse laser deposition (PLD) method, an ion beam sputtering method, an ion assisting method, an ion plating method, a vacuum vapor deposition method, an atomic layer deposition (ALD) method, and a chemical vapor deposition (CVD) method.

Examples of the wet film formation method include a sol-gel method. The sol-gel method is a method of producing a gel through a chemical reaction such as hydrolysis, polymerization, or condensation in a solution, and subsequently promoting densification of the gel by a heating treatment. When using the sol-gel method, the method for applying the sol solution is not particularly limited and may be appropriately selected depending on the intended purpose. Examples of the method include a dipping method, a spraying method, a wire bar method, a spin coating method, a roller coating method, a blade coating method, and a gravure coating method, and wet printing methods such as letterpress, offset printing, gravure printing, intaglio printing, rubber plate printing, and screen printing. The temperature in the heating treatment after the sol solution is applied is preferably 80 degrees C or higher and more preferably 100 degrees C or higher.

The method for applying the compound on the electron transporting material is not particularly limited and may be appropriately selected depending on the intended purpose. Examples of the method include a method of applying a solution containing the compound on the thin film of the electron transporting material, and subsequently drying the resultant.

The applying method is not particularly limited and may be appropriately selected depending on the intended purpose. Examples of the applying method include a dipping method, a spray method, a wire bar method, a spin coating method, a roller coating method, a blade coating method, and a gravure coating method.

The temperature in the drying treatment after the solution is applied is preferably 40 degrees C or higher and more preferably 50 degrees C or higher.

### <<Porous layer>>

The porous layer is not particularly limited and may be appropriately selected depending on the intended purpose so long as the porous layer contains an electron transporting material and is a layer that is not denser than the dense layer (i.e., a layer that is porous). An electron transporting layer formed in a porous state can stabilize crystal growth of the perovskite layer.

A layer that is not denser than the dense layer represents a porous layer having a filling density lower than the filling density of the dense layer.

Examples of the electron transporting material in the porous layer include semiconductor materials used in the dense layer. Among these materials, titanium oxide is preferable.

The film thickness of the porous layer is not particularly limited, may be appropriately selected depending on the intended purpose, and is preferably 0.05 micrometers or greater but 1 micrometer or less and more preferably 0.1 micrometers or greater but 0.4 micrometers or less.

### <Perovskite layer>

The perovskite layer represents a layer that contains a perovskite compound represented by General formula (1) below, and absorbs light and sensitizes the electron transporting layer. Therefore, it is preferable that the perovskite layer be disposed in a manner to adjoin the electron transporting layer.

XαYβZγ --- General formula (1)

In General formula (1), a ratio α:β:γ is 3:1:1, β and γ represent integers greater than 1, X represents a halogen atom, Y represents an organic compound containing an amino group, and Z represents a metal ion.

In the photoelectric conversion elements, the perovskite layers are separated by the hole transporting layers, and are further separated by the second electrodes. As a result, electron diffusion can be prevented.

The shape and size of the perovskite layer are not particularly limited and may be appropriately selected depending on the intended purpose.

The perovskite compound is a composite substance of an organic compound and an inorganic compound, and represented by General formula (1) below.

XαYβMγ --- General formula (1)

In General formula (1), a ratio α:β:γ is 3:1:1, β and γ represent integers greater than 1. For example, X may be a halogen ion, Y may be an ion of an organic compound containing an amino group, and M may be a metal ion.

In General formula (1), X is not particularly limited and may be appropriately selected depending on the intended purpose. Examples of X include ions of halogens such as chlorine, bromine, and iodine. One of these halogen ions may be used alone or two or more of these halogen ions may be used in combination.

In General formula (1), examples of Y include: ions of alkyl amine compounds such as methyl amine, ethyl amine, n-butyl amine, and formamidine; and cesium, potassium, and rubidium. For example, a halogenated lead-methyl ammonium perovskite compound has a light absorption spectral peak λmax at about 350 nm when the halogen ion is Cl, at about 410 nm when the halogen ion is Br, and at about 540 nm when the halogen ion is I. The peaks shift to the longer wavelength ranges. Therefore, the spectrum (band) that can be used differs.

In General formula (1), M is not particularly limited and may be appropriately selected depending on the intended purpose. Examples of M include ions of metals such as lead, indium, antimony, tin, copper, and bismuth.

It is preferable that the perovskite layer have a layered perovskite structure in which layers formed of a halogenated metal and layers in which organic cation molecules are oriented are laminated alternately.

The method for forming the perovskite layer is not particularly limited and may be appropriately selected depending on the intended purpose. Examples of the method include a method of applying a solution in which a halogenated metal and halogenated alkyl amine are dissolved or dispersed, and subsequently drying the solution.

Other examples of the method for forming the perovskite layer include a two-stage precipitation method of applying and drying a solution in which a halogenated metal is dissolved or dispersed, and subsequently immersing the resultant in a solution in which halogenated alkyl amine is dissolved, to form a perovskite compound.

Other examples of the method for forming the perovskite layer include a method of adding a poor solvent for perovskite compounds (i.e., a solvent in which perovskite compounds have a low solubility) while applying a solution in which a halogenated metal and halogenated alkyl amine are dissolved or dispersed, to precipitate a crystal. Other examples of the method for forming the perovskite layer include a method of depositing a halogenated metal by vapor deposition in a gas filled with, for example, methyl amine.

Among these methods, the method of adding a poor solvent for perovskite compounds while applying a solution in which a halogenated metal and halogenated alkyl amine are dissolved or dispersed, to precipitate a crystal is preferable.

The method for applying the solution is not particularly limited and may be appropriately selected depending on the intended purpose. Examples of the method include an immersion method, a spin coating method, a spray method, a dipping method, a roller method, and an air knife method. Other examples of the method for applying the solution include a method of precipitating the solute or dispersoid in a supercritical fluid using, for example, carbon dioxide.

The perovskite layer may contain a sensitizing dye.

The method for forming the perovskite layer containing a sensitizing dye is not particularly limited and may be appropriately selected depending on the intended purpose. Examples of the method include a method of mixing the perovskite compound and a sensitizing dye, and a method of forming a perovskite layer and subsequently adsorbing a sensitizing dye to the perovskite layer.

The sensitizing dye is not particularly limited and may be appropriately selected depending on the intended purpose so long as the sensitizing dye is a compound that is photoexcited by excitation light used.

Examples of the sensitizing dye include metal complex compounds, coumarin compounds, polyene compounds, indoline compounds, thiophene compounds, cyanine pigments, merocyanine pigments, 9-aryl xanthene compounds, triaryl methane compounds, phthalocyanine compounds, and porphyrin compounds.

Examples of the metal complex compounds include the metal complex compounds described in, for example, Japanese Translation of PCT International Application Publication No. JP-T-07-500630, Japanese Unexamined Patent Application Publication No. 10-233238, Japanese Unexamined Patent Application Publication No. 2000-26487, Japanese Unexamined Patent Application Publication No. 2000-323191, and Japanese Unexamined Patent Application Publication No. 2001-59062.

Examples of the coumarin compounds include the coumarin compounds described in, for example, Japanese Unexamined Patent Application Publication No. 10-93118, Japanese Unexamined Patent Application Publication No. 2002-164089, Japanese Unexamined Patent Application Publication No. 2004-95450, and J. Phys. Chem. C, 7224, Vol. 111 (2007).

Examples of the polyene compounds include the polyene compounds described in, for example, Japanese Unexamined Patent Application Publication No. 2004-95450, and Chem. Commun., 4887 (2007).

Examples of the indoline compounds include the indoline compounds described in, for example, Japanese Unexamined Patent Application Publication No. 2003-264010, Japanese Unexamined Patent Application Publication No. 2004-63274, Japanese Unexamined Patent Application Publication No. 2004-115636, Japanese Unexamined Patent Application Publication No. 2004-200068, Japanese Unexamined Patent Application Publication No. 2004-235052, J. Am. Chem. Soc., 12218, Vol. 126 (2004), Chem. Commun., 3036 (2003), and Angew. Chem. Int. Ed., 1923, Vol. 47 (2008).

Examples of the thiophene compounds include the thiophene compounds described in, for example, J. Am. Chem. Soc., 16701, Vol. 128 (2006), and J. Am. Chem. Soc., 14256, Vol. 128 (2006).

Examples of the cyanine pigments include the cyanine pigments described in, for example, Japanese Unexamined Patent Application Publication No. 11-86916, Japanese Unexamined Patent Application Publication No. 11-214730, Japanese Unexamined Patent Application Publication No. 2000-106224, Japanese Unexamined Patent Application Publication No. 2001-76773, and Japanese Unexamined Patent Application Publication No. 2003-7359.

Examples of the merocyanine pigments include the merocyanine pigments described in, for example, Japanese Unexamined Patent Application Publication No. 11-214731, Japanese Unexamined Patent Application Publication No. 11-238905, Japanese Unexamined Patent Application Publication No. 2001-52766, Japanese Unexamined Patent Application Publication No. 2001-76775, and Japanese Unexamined Patent Application Publication No. 2003-7360.

Examples of the 9-aryl xanthene compounds include the 9-aryl xanthene compounds described in, for example, Japanese Unexamined Patent Application Publication No. 10-92477, Japanese Unexamined Patent Application Publication No. 11-273754, Japanese Unexamined Patent Application Publication No. 11-273755, and Japanese Unexamined Patent Application Publication No. 2003-31273.

Examples of the triaryl methane compounds include the triaryl methane compounds described in, for example, Japanese Unexamined Patent Application Publication No. 10-93118, and Japanese Unexamined Patent Application Publication No. 2003-31273.

Examples of the phthalocyanine compounds and the porphyrin compounds include the phthalocyanine compounds and the porphyrin compounds described in, for example, Japanese Unexamined Patent Application Publication No. 9-199744, Japanese Unexamined Patent Application Publication No. 10-233238, Japanese Unexamined Patent Application Publication No. 11-204821, Japanese Unexamined Patent Application Publication No. 11-265738, J. Phys. Chem., 2342, Vol. 91 (1987), J. Phys. Chem. B, 6272, Vol. 97 (1993), Electroanal. Chem., 31, Vol. 537 (2002), Japanese Unexamined Patent Application Publication No. 2006-032260, J. Porphyrins Phthalocyanines, 230, Vol. 3 (1999), Angew. Chem. Int. Ed., 373, Vol. 46 (2007), and Langmuir, 5436, Vol. 24 (2008).

Among these sensitizing dyes, the metal complex compounds, the indoline compound, the thiophene compounds, and the porphyrin compounds are preferable.

### <Organic salt and inorganic salt>

It is preferable that the photoelectric conversion elements contain a salt, which is an organic salt or an inorganic salt, or both, between the perovskite layer and the hole transporting layer.

The photoelectric conversion elements containing the salt between the perovskite layer and the hole transporting layer are expected to have controlled interfacial properties.

When the perovskite layer is a perovskite layer, it is preferable that the salt be a different salt from a salt constituting the perovskite layer.

The salt is not particularly limited and may be appropriately selected depending on the intended purpose. Particularly when a perovskite compound is used in the perovskite layer, it is preferable that the salt contain a halogen atom as a cation in terms of compatibility. Examples of halogen include chlorine, iodine, and bromine.

Particularly when a perovskite compound is used in the perovskite layer, the organic salt is preferably a halogenated hydroacid salt of amine in terms of compatibility.

Particularly when a perovskite compound is used in the perovskite layer, the inorganic salt is preferably a halide of an alkali metal in terms of compatibility. Examples of the alkali metal include lithium, sodium, potassium, rubidium, and cesium.

Examples of the halogenated hydroacid salt of amine include n-butyl amine hydrobromide, n-butyl amine hydroiodide, n-hexyl amine hydrobromide, n-hexyl amine hydroiodide, n-decyl amine hydrobromide, n-octadecyl amine hydroiodide, pyridine hydrobromide, aniline hydroiodide, hydrazine dihydrobromide, ethylene diamine dihydroiodide, 2-phenylethyl amine hydroiodide, phenylene diamine dihydrochloride, diphenyl amine hydrobromide, diphenyl amine hydroiodide, benzyl amine hydroiodide, and 4-diphenylaminophenethyl amine hydroiodide.

Examples of the halide of the alkali metal include cesium iodide, cesium bromide, rubidium iodide, and potassium iodide.

The method for providing the salt, which is the organic salt or the inorganic salt, or both, between the perovskite layer and the hole transporting layer is not particularly limited and may be appropriately selected depending on the intended purpose. Examples of the method include a method of applying a solution containing the salt on the perovskite layer, subsequently drying the solution, and subsequently further forming the hole transporting layer on the resultant. Examples of the solution include an aqueous solution and an alcohol solution.

The applying method is not particularly limited and may be appropriately selected depending on the intended purpose. Examples of the applying method include a dipping method, a spray method, a wire bar method, a spin coating method, a roller coating method, a blade coating method, and a gravure coating method.

The temperature in the drying treatment after the solution is applied is not particularly limited and may be appropriately selected depending on the intended purpose.

### <Hole transporting layer>

The hole transporting layer represents a layer that transports holes (positive holes) produced in the perovskite layer to the second electrode described below. Therefore, it is preferable that the hole transporting layer be disposed in a manner to adjoin the perovskite layer via the salt described above.

In the photoelectric conversion elements, the hole transporting layers are formed in a manner to separate the first electrodes, the electron transporting layers, and the perovskite layers. As a result, electron diffusion can be prevented.

In the photoelectric conversion elements, the hole transporting layers are separated by the second electrodes.

The hole transporting layer is not particularly limited and may be appropriately selected depending on the intended purpose so long as the hole transporting layer can separate the electron transporting layers and the perovskite layers in at least two photoelectric conversion elements adjoining each other.

When the first electrodes, the electron transporting layers, and the perovskite layers are separated by the hole transporting layers in at least two photoelectric conversion elements adjoining each other, there are fewer chances of electron recombination due to diffusion. This makes it possible to maintain the power generation efficiency even through exposure to high-illuminance light for a long time.

The hole transporting layer contains a solid hole transporting material, and further contains other materials as needed.

The solid hole transporting material (hereinafter may be referred to simply as "hole transporting material") is not particularly limited and may be appropriately selected depending on the intended purpose so long as the solid hole transporting material has a characteristic that enables transportation of holes. An organic compound is preferable.

When using an organic compound as the hole transporting material, it is possible to use known materials. Examples of the hole transporting material include low-molecular-weight compounds, high-molecular-weight compounds, and mixtures of these compounds.

When using a high-molecular-weight compound as the hole transporting material, it is particularly preferable to use a polymer having a molecular weight of 2,000 or greater.

The polymeric material used in the hole transporting layer is not particularly limited and may be appropriately selected depending on the intended purpose. Examples of the polymeric material include polythiophene compounds, polyphenylene vinylene compounds, polyfluorene compounds, polyphenylene compounds, polyarylamine compounds, and polythiadiazole compounds.

Examples of the polythiophene compounds include poly(3-n-hexylthiophene), poly(3-n-octyloxythiophene), poly(9,9'-dioctyl-fluorene-co-bithiophene), poly(3,3‴-didodecyl-quarterthiophene), poly(3,6-dioctylthieno[3,2-b]thiophene), poly(2,5-bis(3-decylthiophen-2-yl)thieno[3,2-b]thiophene), poly(3,4-didecylthiophene-co-thieno[3,2-b]thiophene), poly(3,6-dioctylthieno[3,2-b]thiophene-co-thieno[3,2-b]thiophene), poly(3,6-dioctylthieno[3,2-b]thiophene-co-thiophene), and poly(3,6-dioctylthieno[3,2-b]thiophene-co-bithiophene).

Examples of the polyphenylene vinylene compounds include poly[2-methoxy-5-(2-ethylhexyloxy)-1,4-phenylenevinylene), poly[2-methoxy-5-(3,7-dimethyloctyloxy)-1,4-phenylenevinylene], and poly[(2-methoxy-5-(2-ethylphexyloxy)-1,4-phenylenevinylene)-co-(4,4'-biphenylene-vinylene)].

Examples of the polyfluorene compounds include poly(9,9'-didodecylfluorenyl-2,7-diyl), poly[(9,9-dioctyl-2,7-divinylenefluorene)-alt-co-(9,10-anthracene)], poly[(9,9-dioctyl-2,7-divinylenefluorene)-alt-co-(4,4'-biphenylene)], poly[(9,9-dioctyl-2,7-divinylenefluorene)-alt-co-(2-methoxy-5-(2-ethylhexyloxy)-1,4-phenylene)], and poly[(9,9-dioctyl-2,7-diyl)-co-(1,4-(2,5-dihexyloxy)benzene)].

Examples of the polyphenylene compounds include poly[2,5-dioctyloxy-1,4-phenylene], and poly[2,5-di(2-ethylhexyloxy-1,4-phenylene].

Examples of the polyarylamine compounds include poly[(9,9-dioctylfluorenyl-2,7-diyl)-alt-co-(N,N'-diphenyl)-N,N'-di(p-hexylphenyl)-1,4-diaminobenzene], poly[(9,9-dioctylfluorenyl-2,7-diyl)-alt-co-(N,N'-bis(4-octyloxyphenyl)benzidine-N,N'-(1,4-diphenylene)], poly[(N,N'-bis(4-octyloxyphenyl)benzidine-N,N'-(1,4-diphenylene)], poly[(N,N'-bis(4-(2-ethylhexyloxy)phenyl)benzidine-N,N'-(1,4-diphenylene)], poly [phenylimino-1,4-phenylenevinylene-2,5-dioctyloxy-1,4-phenylenevinylene -1,4-phenylene], poly[p-tolylimino-1,4-phenylenevinylene -2,5-di(2-ethylhexyloxy) -1,4-phenylenevinylene-1,4-phenylene], and poly[4-(2-ethylhexyloxy)phenylimino-1,4-biphenylene].

Examples of the polythiadiazole compounds include poly[(9,9-dioctylfluorenyl-2,7-diyl)-alt-co-(1,4-benzo(2,1',3)thiadiazole], and poly(3,4-didecylthiophene-co-(1,4-benzo(2,1',3)thiadiazole). Among these polymeric materials, the polythiophene compounds and the polyarylamine compounds are preferable considering carrier mobility and ionization potential. Moreover, a compound represented by General formula (2) below or a compound represented by General formula (3) below, or both are preferable.

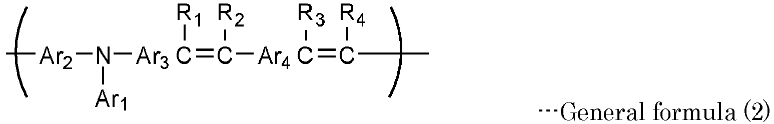

In General formula (2), Ar₁ represents an aryl group. Examples of the aryl group include a phenyl group, a 1-naphthyl group, and a 9-anthracenyl group. The aryl group may contain a substituent. Examples of the substituent include an alkyl group, an alkoxy group, and an aryl group. Ar₂, Ar₃, and Ar₄ each independently represent, for example, an arylene group and a divalent heterocyclic group. Examples of the arylene group include 1,4-phenylene, 1,1'-biphenylene, and 9,9'-di-n-hexyl fluorene. Examples of the divalent heterocyclic group include 2,5-thiophene. R₁ to R₄ each independently represent, for example, a hydrogen atom, an alkyl group, and an aryl group. Examples of the alkyl group include a methyl group and an ethyl group. Examples of the aryl group include a phenyl group and a 2-naphthyl group. The alkyl group and the aryl group may contain a substituent.

Specific examples of the polymers represented by General formula (2) above include, but are not limited to, (A-Ol) to (A-22) presented below.

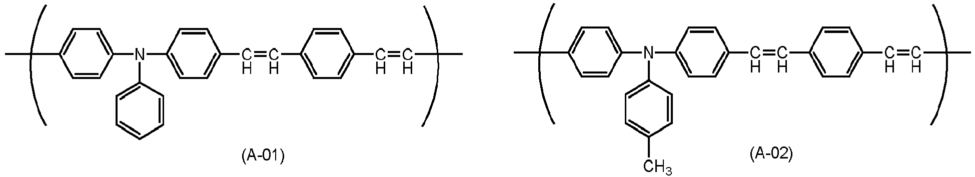

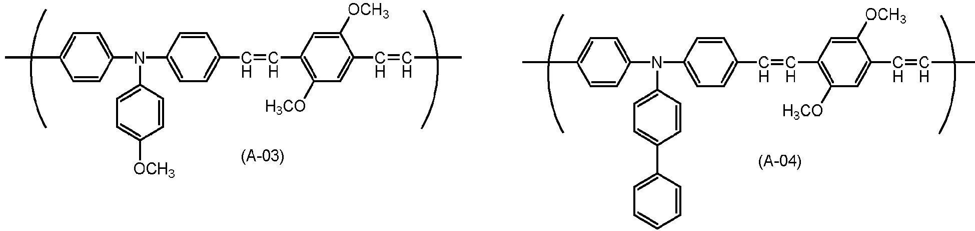

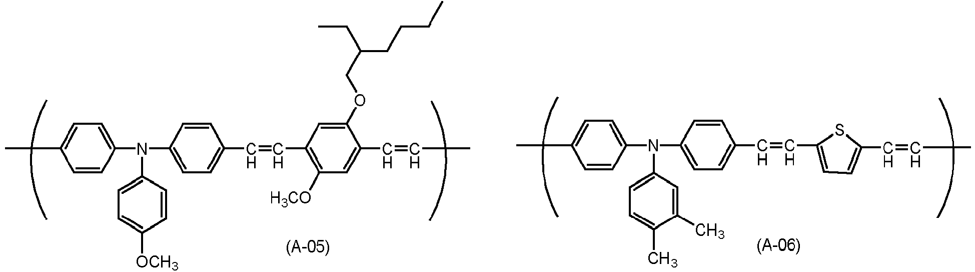

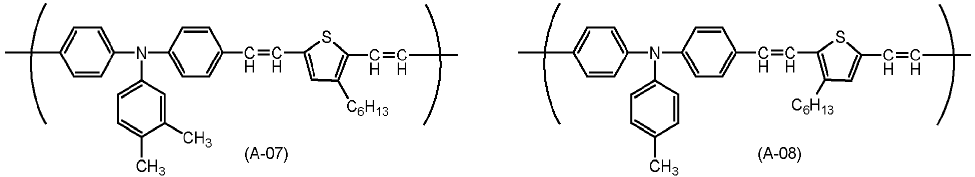

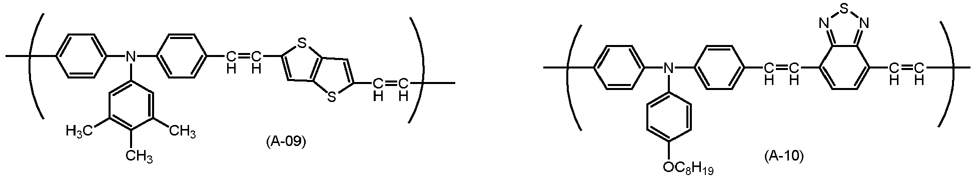

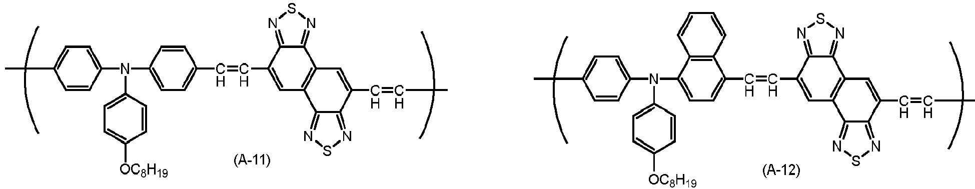

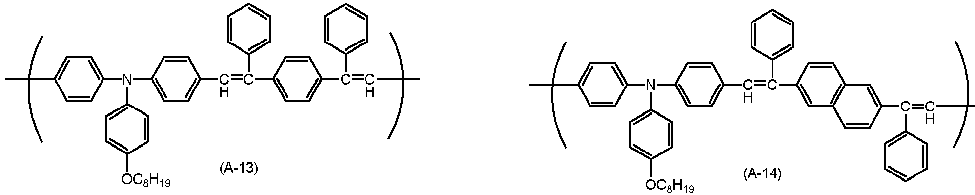

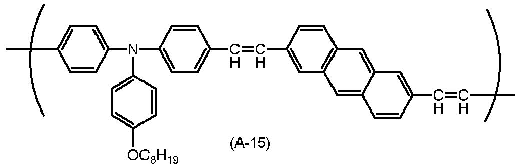

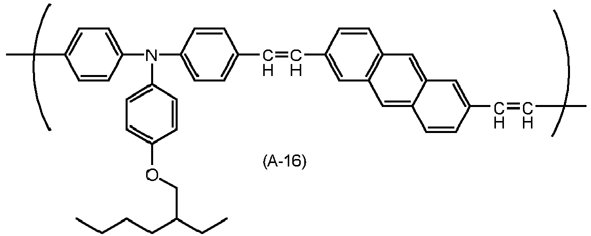

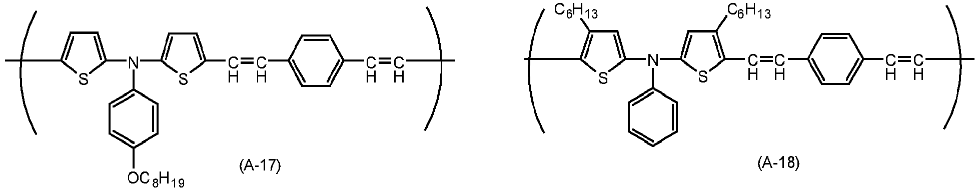

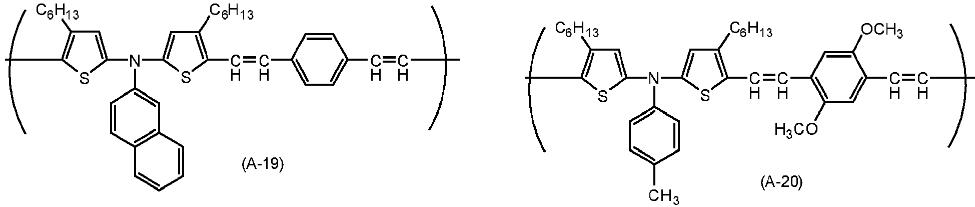

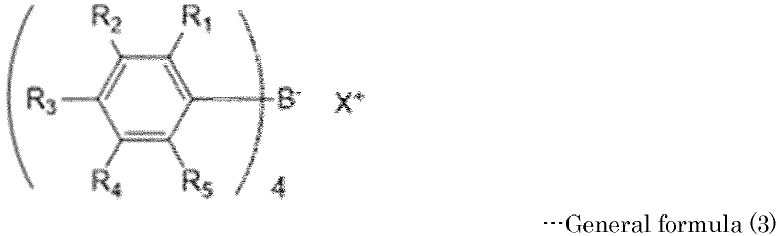

In General formula (3), R₁ to R₅ represent a hydrogen atom, a halogen atom, an alkyl group, an alkoxy group, or an aryl group, and may be the same as or different from one another. X represents a cation. R₁ and R₂, or R₂ and R₃ may form a cyclic structure together.

Examples of the halogen atom include a chlorine atom, a bromine atom, and an iodine atom.

Examples of the alkyl group include an alkyl group containing from 1 through 6 carbon atoms. A halogen atom may be substituted for the alkyl group.

Examples of the alkoxy group include an alkoxy group containing from 1 through 6 carbon atoms.

Examples of the aryl group include a phenyl group.

The cation is not particularly limited and may be appropriately selected depending on the intended purpose. Examples of the cation include alkali metal cations, a phosphonium cation, an iodonium cation, nitrogen-containing cations, and a sulfonium cation. The nitrogen-containing cations represent ions having a positive charge on a nitrogen atom. Examples of the nitrogen-containing cations include an ammonium cation, a pyridinium cation, and an imidazolium cation.

Specific examples of the compounds represented by General formula (3) include, but are not limited to, (B-1) to (B-28) presented below.

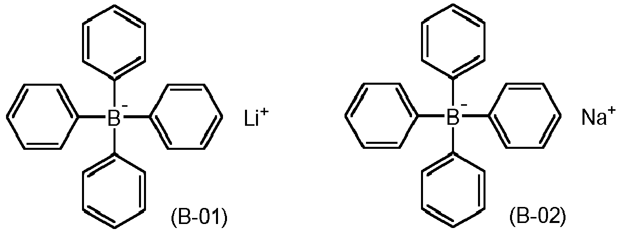

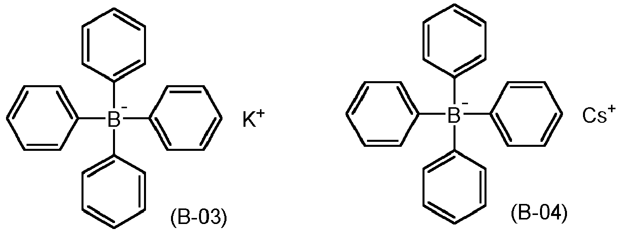

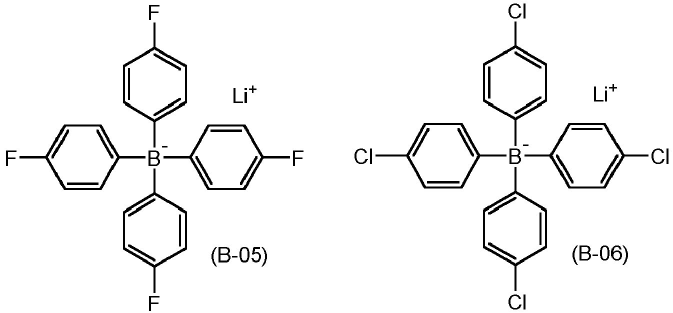

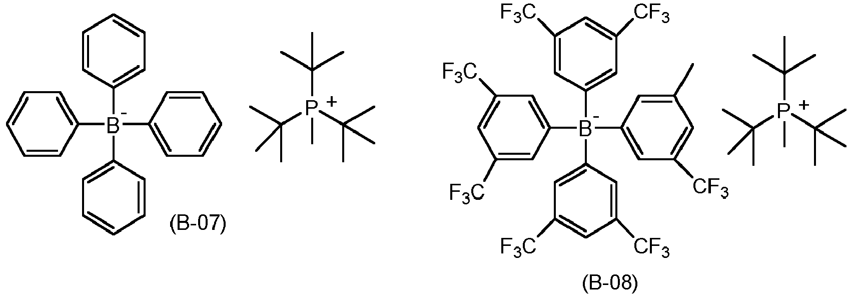

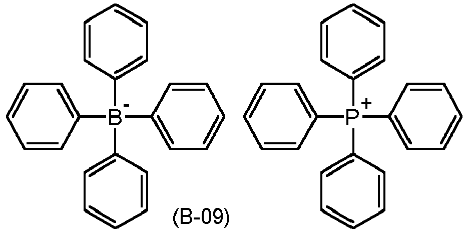

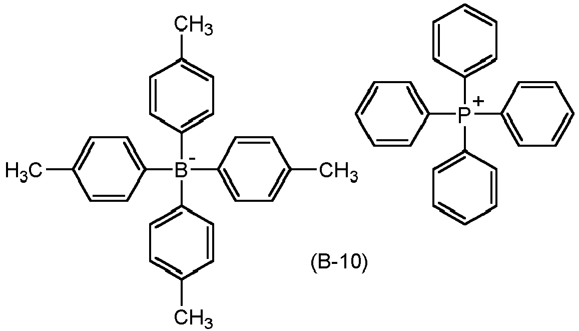

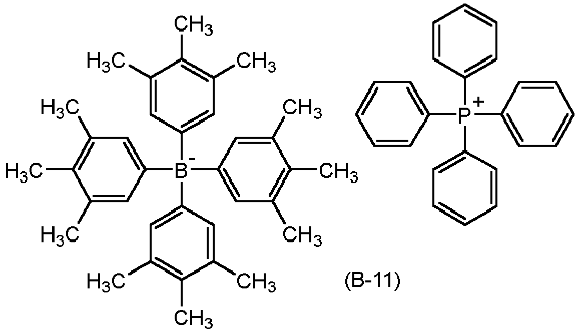

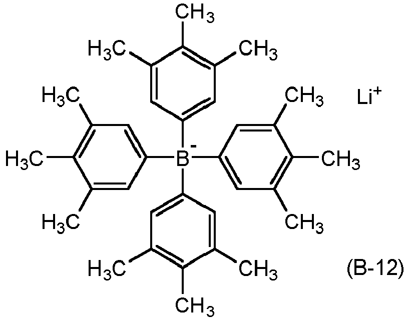

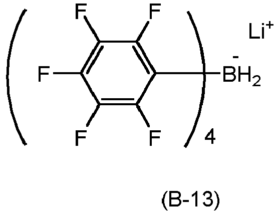

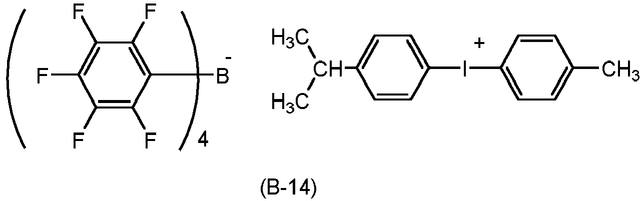

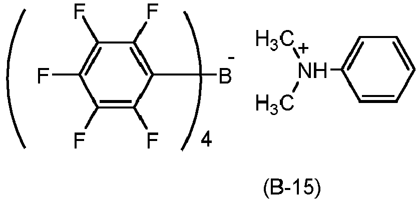

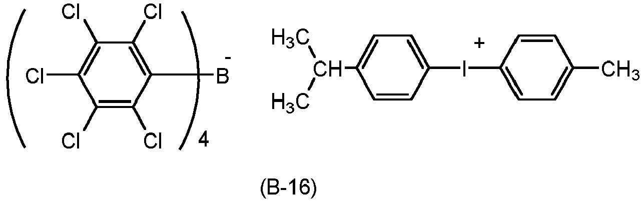

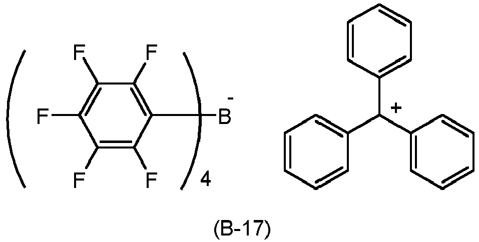

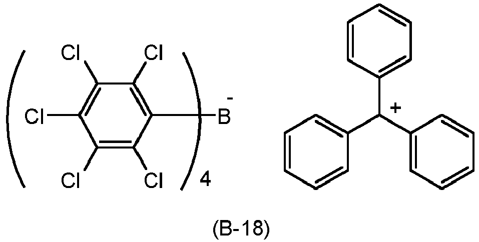

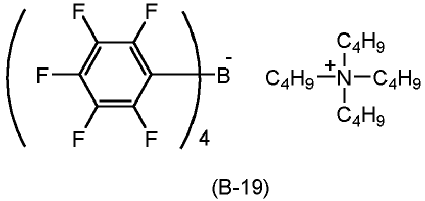

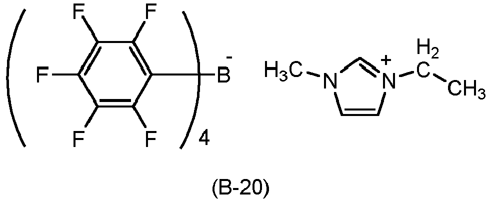

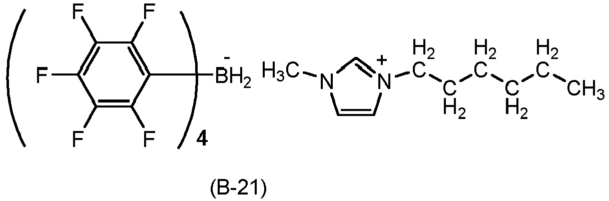

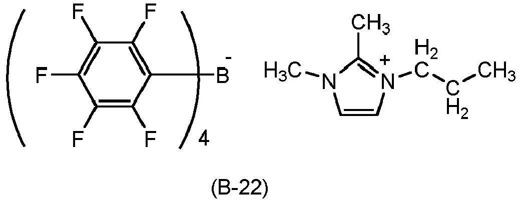

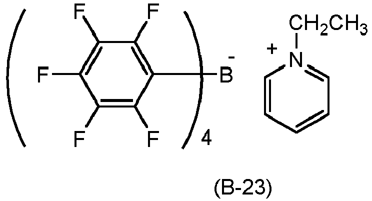

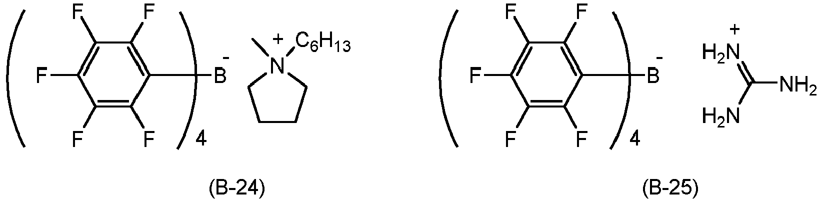

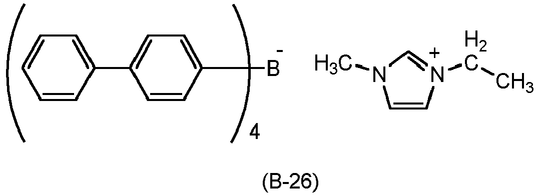

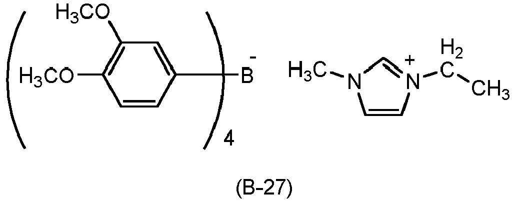

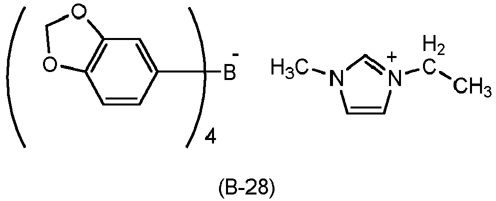

The mass ratio [(2):(3)] between the polymeric compound (2) containing the repeating structure represented by General formula (2) above and the compound (3) represented by General formula (3) in the hole transporting layer is not particularly limited, may be appropriately selected depending on the intended purpose, and is preferably from 1,000:1 through 1,000:500, and more preferably from 1,000:5 through 1,000:300 in terms of hole migration.

The hole transporting layer further contains, for example, another solid hole transporting material, and contains other materials as needed.

The another solid hole transporting material (hereinafter may be referred to simply as "hole transporting material") is not particularly limited and may be appropriately selected depending on the intended purpose so long as the another solid hole transporting material has a characteristic that enables transportation of holes. An organic compound is preferable.

When using an organic compound as the hole transporting material, the hole transporting layer contains, for example, a plurality of kinds of compounds.

Examples of the organic compound include a polymeric material.

The polymeric material used in the hole transporting layer is not particularly limited and may be appropriately selected depending on the intended purpose. Examples of the polymeric material include polythiophene compounds, polyphenylene vinylene compounds, polyfluorene compounds, polyphenylene compounds, polyarylamine compounds, and polythiadiazole compounds.

Examples of the polythiophene compounds include poly(3-n-hexylthiophene), poly(3-n-octyloxythiophene), poly(9,9'-dioctyl-fluorene-co-bithiophene), poly(3,3‴-didodecyl-quarterthiophene), poly(3,6-dioctylthieno[3,2-b]thiophene), poly(2,5-bis(3-decylthiophen-2-yl)thieno[3,2-b]thiophene), poly(3,4-didecylthiophene-co-thieno[3,2-b]thiophene), poly(3,6-dioctylthieno[3,2-b]thiophene-co-thieno[3,2-b]thiophene), poly(3,6-dioctylthieno[3,2-b]thiophene-co-thiophene), and poly(3,6-dioctylthieno[3,2-b]thiophene-co-bithiophene).

Examples of the polyphenylene vinylene compounds include poly[2-methoxy-5-(2-ethylhexyloxy)-1,4-phenylenevinylene), poly[2-methoxy-5-(3,7-dimethyloctyloxy)-1,4-phenylenevinylene], and poly[(2-methoxy-5-(2-ethylphexyloxy)-1,4-phenylenevinylene)-co-(4,4'-biphenylene-vinylene)].

Examples of the polyfluorene compounds include poly(9,9'-didodecylfluorenyl-2,7-diyl), poly[(9,9-dioctyl-2,7-divinylenefluorene)-alt-co-(9,10-anthracene)], poly[(9,9-dioctyl-2,7-divinylenefluorene)-alt-co-(4,4'-biphenylene)], poly[(9,9-dioctyl-2,7-divinylenefluorene)-alt-co-(2-methoxy-5-(2-ethylhexyloxy)-1,4-phenylene)], and poly[(9,9-dioctyl-2,7-diyl)-co-(1,4-(2,5-dihexyloxy)benzene)].

Examples of the polyphenylene compounds include poly[2,5-dioctyloxy-1,4-phenylene], and poly[2,5-di(2-ethylhexyloxy-1,4-phenylene].

Examples of the polythiadiazole compounds include poly[(9,9-dioctylfluorenyl-2,7-dlyl)-alt-co-(1,4-benzo(2,1',3)thiadiazole], and poly(3,4-didecylthiophene-co-(1,4-benzo(2,1',3)thiadiazole).

The hole transporting layer may contain not only the polymeric compound described above, but also a low-molecular-weight compound alone or a mixture of a low-molecular-weight compound and a polymer. The chemical structure of the low-molecular-weight hole transporting material is not particularly limited. Examples of the low-molecular-weight hole transporting material include oxadiazole compounds, triphenylmethane compounds, pyrazoline compounds, hydrazone compounds, tetraaryl benzidine compounds, stilbene compounds, spirobifluorene compounds, and thiophene oligomers. Examples of the oxadiazole compounds include the oxadiazole compounds described in, for example, Japanese Examined Patent Publication No. 34-5466, and Japanese Unexamined Patent Application Publication No. 56-123544.

Examples of the triphenylmethane compounds include the triphenylmethane compounds described in, for example, Japanese Examined Patent Publication No. 45-555.

Examples of the pyrazoline compounds include the pyrazoline compounds described in, for example, Japanese Examined Patent Publication No. 52-4188.

Examples of the hydrazone compounds include the hydrazone compounds described in, for example, Japanese Examined Patent Publication No. 55-42380.

Examples of the tetraarylbenzidine compounds include the tetraarylbenzidine compounds described in, for example, Japanese Unexamined Patent Application Publication No. 54-58445.

Examples of the stilbene compounds include the stilbene compounds described in, for example, Japanese Unexamined Patent Application Publication No. 58-65440, and Japanese Unexamined Patent Application Publication No. 60-98437.

Examples of the spirobifluorene compounds include the spirobifluorene compounds described in, for example, Japanese Unexamined Patent Application Publication No. 2007-115665, Japanese Unexamined Patent Application Publication No. 2014-72327, Japanese Unexamined Patent Application Publication No. 2001-257012, WO 2004/063283, WO 2011/030450, WO 2011/45321, WO 2013/042699, and WO 2013/121835. Examples of the thiophene oligomers include the thiophene oligomers described in, for example, Japanese Unexamined Patent Application Publication No. 02-250881, and Japanese Unexamined Patent Application Publication No. 2013-033868.

Among these a low-molecular-weight hole transporting materials, the spirobifluorene compounds are preferable, and a spirobifluorene compound represented by General formula (5) below is more preferable.

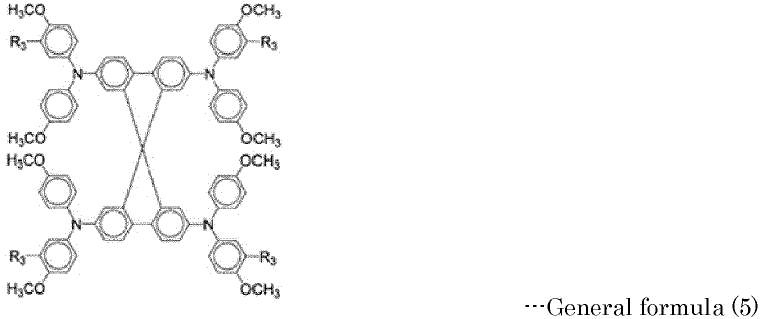

In General formula (5), R3 represents a hydrogen atom or an alkyl group.

When mixing a polymeric compound and a low-molecular-weight compound, it is preferable that the ionization potential difference between the polymeric compound and the low-molecular-weight compound be 0.2 eV or less. The ionization potential is energy needed for withdrawing one electron from a molecule, and is expressed by the electronvolt (eV) unit. The method for measuring the ionization potential is not particularly limited. Measurement by a photoelectron spectroscopy method is preferable.

The other materials contained in the hole transporting layer are not particularly limited and may be appropriately selected depending on the intended purpose. Examples of the other materials include additives and an oxidant.

The additives are not particularly limited and may be appropriately selected depending on the intended purpose. Examples of the additives include iodine, metal iodides such as lithium iodide, sodium iodide, potassium iodide, cesium iodide, calcium iodide, copper iodide, iron iodide, and silver iodide, quaternary ammonium salts such as tetraalkyl ammonium iodide and pyridinium iodide, metal bromides such as lithium bromide, sodium bromide, potassium bromide, cesium bromide, and calcium bromide, quaternary ammonium compound bromine salts such as tetraalkyl ammonium bromide and pyridinium bromide, metal chlorides such as copper chloride and silver chloride, acetic acid metal salts such as copper acetate, silver acetate, and palladium acetate, sulfuric acid metal salts such as copper sulfate and zinc sulfate, metal complexes such as ferrocyanide-ferricyanide and ferrocene-ferricinium ion, sulfur compounds such as polysodium sulfide and alkylthiol-alkyl disulfide, viologen pigments, hydroquinone, ionic liquids described in Inorg. Chem. 35 (1996) 1168, such as 1,2-dimethyl-3-n-propyl imidazolinium iodide, 1-methyl-3-n-hexyl imidazolinium iodide, 1,2-dimethyl-3-ethyl imidazolium trifluoromethane sulfonate, 1-methyl-3-butyl imidazolium nonafluorobutyl sulfonate, and 1-methyl-3-ethyl imidazolium bis(trifluoromethyl)sulfonylimide, basic compounds such as pyridine, 4-t-butyl pyridine, and benzimidazole, or lithium compounds such as lithium trifluoromethane sulfonylimide and lithium diisopropylimide.

The oxidant is not particularly limited and may be appropriately selected depending on the intended purpose. Examples of the oxidant include tris(4-bromophenyl)aminium hexachloroantimonate, silver hexafluoroantimonate, nitrosonium tetrafluoroborate, silver nitrate, and cobalt complexes. The hole transporting material needs not be entirely oxidized by the oxidant, but partial oxidization is effective. The oxidant may or may not be removed to outside the system after reaction.

When the hole transporting layer contains the oxidant, the hole transporting material can be partially or entirely radical-cationized. Therefore, the hole transporting layer can have an improved conductivity and improved output characteristic durability and stability.

The average thickness of the hole transporting layer is not particularly limited, may be appropriately selected depending on the intended purpose, and is preferably 0.01 micrometers or greater but 20 micrometers or less, more preferably 0.1 micrometers or greater but 10 micrometers or less, and yet more preferably 0.2 micrometers or greater but 2 micrometers or less on the perovskite layer.

The hole transporting layer can be directly formed on the perovskite layer. The method for producing the hole transporting layer is not particularly limited and may be appropriately selected depending on the intended purpose. Examples of the method include a method of forming a thin film in a vacuum, such as vacuum vapor deposition, and a wet film formation method. Among these methods, the wet film formation method is particularly preferable in terms of production costs, and a method of applying the hole transporting layer on the perovskite layer is more preferable.

The wet film formation method is not particularly limited and may be appropriately selected depending on the intended purpose. Examples of the wet film formation method include a dipping method, a spray method, a wire bar method, a spin coating method, a roller coating method, a blade coating method, and a gravure coating method. Moreover, as a wet printing method, for example, letterpress, offset printing, gravure printing, intaglio printing, rubber plate printing, and screen printing may be employed.

For example, the hole transporting layer may be produced by film formation in a supercritical fluid, or in a subcritical fluid having a temperature and a pressure that are lower than the critical points.

A supercritical fluid represents a fluid that exists in the form of a noncondensable high-density fluid in temperature and pressure regions beyond the limits (critical points) until which a gas and a liquid can coexist, and does not condense when compressed, and has a temperature higher than or equal to the critical temperature and a pressure higher than or equal to the critical pressure. The supercritical fluid is not particularly limited and may be appropriately selected depending on the intended purpose. A supercritical fluid having a lower critical temperature is more preferable.

The subcritical fluid is not particularly limited and may be appropriately selected depending on the intended purpose so long as the subcritical fluid is a fluid that exists in the form of a high-pressure liquid in temperature and pressure regions near the critical points. Any fluid that are raised as examples of the supercritical fluid can be suitably used also as a subcritical fluid.

Examples of the supercritical fluid include carbon monoxide, carbon dioxide, ammonia, nitrogen, water, alcohol solvents, hydrocarbon solvents, halogen solvents, and ether solvents.

Examples of the alcohol solvents include methanol, ethanol, and n-butanol.

Examples of the hydrocarbon solvents include ethane, propane, 2,3-dimethyl butane, benzene, and toluene. Examples of the halogen solvents include methylene chloride and chlorotrifluoromethane.

Examples of the ether solvents include dimethyl ether.

One of these supercritical fluids may be used alone or two or more of these supercritical fluids may be used in combination.

Among these supercritical fluids, carbon dioxide is preferable because the supercritical conditions of carbon dioxide, which has a critical pressure of 7.3 MPa and a critical temperature of 31 degrees C, can be easily formed, and because carbon dioxide is incombustible and easy to handle.

The critical temperature and the critical pressure of the supercritical fluid are not particularly limited and may be appropriately selected depending on the intended purpose. The critical temperature of the supercritical fluid is preferably -273 degrees C or higher but 300 degrees C or lower and more preferably 0 degrees C or higher but 200 degrees C or lower.

An organic solvent and an entrainer may be used in combination with the supercritical fluid and the subcritical fluid. Addition of an organic solvent and an entrainer makes it easier to adjust the solubility in the supercritical fluid.

The organic solvent is not particularly limited and may be appropriately selected depending on the intended purpose. Examples of the organic solvent include ketone solvents, ester solvents, ether solvents, amide solvents, halogenated hydrocarbon solvents, and hydrocarbon solvents.

Examples of the ketone solvents include acetone, methyl ethyl ketone, and methyl isobutyl ketone.

Examples of the ester solvents include ethyl formate, ethyl acetate, and n-butyl acetate.

Examples of the ether solvents include diisopropyl ether, dimethoxyethane, tetrahydrofuran, dioxolane, and dioxane.

Examples of the amide solvents include N,N-dimethyl formamide, N,N-dimethyl acetamide, and N-methyl-2-pyrrolidone.

Examples of the halogenated hydrocarbon solvents include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvents include n-pentane, n-hexane, n-octane, 1,5-hexadiene, cyclohexane, methyl cyclohexane, cyclohexadiene, benzene, toluene, o-xylene, m-xylene, p-xylene, ethyl benzene, and cumene.

One of these organic solvents may be used alone or two or more of these organic solvents may be used in combination.

After the hole transporting material is laminated on the perovskite layer, the resultant may be subjected to a press process step. Through the press process, the hole transporting material more closely attaches to the perovskite layer. Therefore, the power generation efficiency may be improved.

The method for the press process is not particularly limited and may be appropriately selected depending on the intended purpose. Examples of the method include a press-forming method using a flat plate represented by an infrared spectroscopy (IR) tablet molder, and a roll press method using, for example, a roller.

The press process pressure is preferably 10 kgf/cm² or higher and more preferably 30 kgf/cm² or higher.

The press process time is not particularly limited, may be appropriately selected depending on the intended purpose, and is preferably 1 hour or shorter. Heat may be applied during the press process.

During the press process, a release agent may be sandwiched between the press machine and the electrode.

The release agent is not particularly limited and may be appropriately selected depending on the intended purpose. Examples of the release agent include fluororesins such as polytetrafluoroethylene, polychlorotrifluoroethylene, tetrafluoroethylene-hexafluoropropylene copolymers, perfluoroalkoxy fluoride resins, polyvinylidene fluoride, ethylene-tetrafluoroethylene copolymers, ethylene-chlorotrifluoroethylene copolymers, and polyvinyl fluoride. One of these release agents may be used alone or two or more of these release agents may be used in combination.

### <Film containing metal oxide>

After the press process, a film containing a metal oxide may be provided between the hole transporting layer and the second electrode before the second electrode is provided.

The metal oxide is not particularly limited and may be appropriately selected depending on the intended purpose. Examples of the metal oxide include molybdenum oxide, tungsten oxide, vanadium oxide, and nickel oxide. One of these metal oxides may be used alone or two or more of these metal oxides may be used in combination. Among these metal oxides, molybdenum oxide is preferable.

The method for providing the film containing the metal oxide on the hole transporting layer is not particularly limited and may be appropriately selected depending on the intended purpose. Examples of the method include thin film formation methods in a vacuum, such as sputtering and vacuum vapor deposition, and a wet film formation method.

As the wet film formation method for forming the film containing the metal oxide, a method of preparing a paste in which a powder or a sol of the metal oxide is dispersed, and applying the paste on the hole transporting layer is preferable.

The wet film formation method is not particularly limited and may be appropriately selected depending on the intended purpose. Examples of the wet film formation method include a dipping method, a spray method, a wire bar method, a spin coating method, a roller coating method, a blade coating method, and a gravure coating method. As a wet printing method, for example, letterpress, offset printing, gravure printing, intaglio printing, rubber plate printing, and screen printing may be employed.

The average thickness of the film containing the metal oxide is not particularly limited, may be appropriately selected depending on the intended purpose, and is preferably 0.1 nm or greater but 50 nm or less and more preferably 1 nm or greater but 10 nm or less.

### <Second electrode>

In the photoelectric conversion elements, the second electrodes are formed in a manner to separate the first electrodes, the electron transporting layers, and the perovskite layers, and it is preferable to form the second electrode on the hole transporting layer or the film containing the metal oxide. The second electrodes formed in a manner to separate the first electrodes, the electron transporting layers, and the perovskite layers in the photoelectric conversion elements can prevent electron diffusion. As the second electrode, the same electrode as the first electrode can be used.

The shape, structure, and size of the second electrode are not particularly limited and may be appropriately selected depending on the intended purpose.

Examples of the material of the second electrode include metals, carbon compounds, conductive metal oxides, and conductive polymers.

Examples of the metals include platinum, gold, silver, copper, and aluminum.

Examples of the carbon compounds include graphite, fullerene, carbon nanotube, and graphene.

Examples of the conductive metal oxides include ITO, FTO, and ATO.

Examples of the conductive polymers include polythiophene and polyaniline.

One of these materials may be used alone or two or more of these materials may be used in combination.

The second electrode can be formed appropriately on the hole transporting layer by such methods as, for example, application, lamination, vacuum vapor deposition, CVD, and pasting depending on the kind of the material used and the kind of the hole transporting layer.

In the photoelectric conversion elements, it is preferable that the first electrode or the second electrode, or both be substantially transparent. For example, it is preferable to make the first electrode transparent and make incident light incident from the first electrode side. In this case, it is preferable to use a light reflecting material as the second electrode, and it is preferable to use metals, glass on which conductive oxides are vapor-deposited, plastics, and metal thin films. It is also effective to provide an antireflection layer on the electrode on the light incident side.

### <Second substrate>

In the solar cell module of the present disclosure, a second substrate may be disposed counter to the first substrate in a manner to sandwich the photoelectric conversion elements.

The shape, structure, and size of the substrate are not particularly limited and may be appropriately selected depending on the intended purpose.

The material of the second substrate is not particularly limited and may be appropriately selected depending on the intended purpose. Examples of the material of the second substrate include glass, plastic films, and ceramic.

In order to improve adhesiveness, a roughened portion may be formed at the joining portion between the second substrate and a sealing member described below.

The method for forming the roughened portion is not particularly limited and may be appropriately selected depending on the intended purpose. Examples of the method include a sandblasting method, a water blasting method, a chemical etching method, a laser machining method, and a method using polishing paper.

Examples of the method for improving adhesiveness between the second substrate and the sealing member include a method of removing any organic substance on the surface of the second substrate, and a method of improving hydrophilicity of the second substrate. The method for removing any organic substance on the surface of the second substrate is not particularly limited and may be appropriately selected depending on the intended purpose. Examples of the method include UV-ozone cleaning, and oxygen plasma treatment.

### <Sealing member>

The sealing member is disposed between the first substrate and the second substrate and configured to seal the photoelectric conversion elements.

The material of the sealing member is not particularly limited and may be appropriately selected depending on the intended purpose. Examples of the material of the sealing member include cured products of acrylic resins and cured products of epoxy resins.

Any known material may be used as the cured product of the acrylic resin so long as such a material is a cured product of a monomer or an oligomer containing an acrylic group in a molecule thereof.

Any known material may be used as the cured product of the epoxy resin so long as such a material is a cured product of a monomer or an oligomer containing an epoxy group in a molecule thereof.

Examples of the acrylic resin include water-dispersible types, solventless-types, solid types, thermosetting types, curing agent-mixed types, and ultraviolet-curable types. Among these acrylic resins, thermosetting types and ultraviolet-curable types are preferable, and ultraviolet-curable types are more preferable. Heating may be applied to ultraviolet-curable resins, and it is preferable to heat the ultraviolet-curable resins even after the ultraviolet-curable resins are cured with ultraviolet rays.

Examples of the epoxy resins include bisphenol A-types, bisphenol F-types, novolac types, alicyclic types, long-chain aliphatic types, glycidyl amine types, glycidyl ether types, and glycidyl ester types. One of these epoxy resins may be used alone or two or more of these epoxy resins may be used in combination.

It is preferable to mix a curing agent and various additives with the epoxy resin as needed.

The curing agent is not particularly limited and may be appropriately selected depending on the intended purpose. The curing agent is classified into, for example, amine-based, acid anhydride-based, polyamide-based, and other curing agents.

Examples of the amine-based curing agent include aliphatic polyamines such as diethylene triamine and triethylene tetramine, and aromatic polyamines such as metaphenylene diamine, diaminodiphenylmethane, and diaminodiphenyl sulfone.

Examples of the acid anhydride-based curing agent include phthalic anhydride, tetra- and hexahydro- phthalic anhydride, methyl tetrahydrophthalic anhydride, methylnadic anhydride, pyromellitic anhydride, HET anhydride, and dodecenyl succinic anhydride.

Examples of the other curing agents include imidazoles and polymercaptan. One of these curing agents may be used alone or two or more of these curing agents may be used in combination.

The additives are not particularly limited and may be appropriately selected depending on the intended purpose. Examples of the additives include a filler, a gapping agent, a polymerization initiator, a desiccant (moisture absorbent), a curing accelerator, a coupling agent, a flexible agent, a colorant, a flame retardant promotor, an antioxidant, and an organic solvent. Among these additives, a filler, a gapping agent, a curing accelerator, a polymerization initiator, and a desiccant (moisture absorbent) are preferable, and a filler and a polymerization initiator are more preferable.

When a filler is added as an additive, effects of, for example, suppressing intrusion of moisture and oxygen, suppressing volume shrinkage during curing, suppressing an amount of an outgas during curing or heating, improving mechanical strength, and controlling thermal conductivity and fluidity can be obtained. Therefore, addition of a filler as an additive is very effective for maintaining a stable output in various environments.

Not only intruding moisture and oxygen, but also an outgas that is emitted during curing or heating of the sealing member are unignorable influences on the output characteristic and durability of the photoelectric conversion elements. Particularly, an outgas emitted during heating is significantly influential on the output characteristic through storage in a high-temperature environment.

When a filler, a gapping agent, and a desiccant are added in the sealing member, these agents not only can suppress intrusion of moisture and oxygen, but also can suppress the amount of the sealing member used, to enable the effect of reducing an outgas. Addition of a filler, a gapping agent, and a desiccant in the sealing member is effective not only during curing, but also during storage of the photoelectric conversion elements in a high-temperature environment.

The filler is not particularly limited and may be appropriately selected depending on the intended purpose. Examples of the filler include inorganic fillers such as crystalline or amorphous silica, talc, alumina, aluminum nitride, silicon nitride, calcium silicate, and calcium carbonate. One of these fillers may be used alone or two or more of these fillers may be used in combination.

The average primary particle diameter of the filler is preferably 0.1 micrometers or greater but 10 micrometers or less and more preferably 1 micrometer or greater but 5 micrometers or less. When the average primary particle dimeter of the filler is in the preferable range described above, the effect of suppressing intrusion of moisture and oxygen can be sufficiently obtained, the viscosity becomes an appropriate level, and adhesiveness with the substrates and a defoaming property are improved. This is effective for control of the width of the sealing member, and for the working efficiency.

The content of the filler is preferably 10 parts by mass or greater but 90 parts by mass or less and more preferably 20 parts by mass or greater but 70 parts by mass or less relative to the whole of the sealing member (100 parts by mass). When the content of the filler is in the preferable range described above, the effect of suppressing intrusion of moisture and oxygen can be sufficiently obtained, the viscosity becomes an appropriate level, and adhesiveness and the working efficiency are good.

The gapping agent is also referred to as gap controlling agent or spacer agent. When a gapping agent is added as an additive, it is possible to control the gap of the sealing member. For example, when providing a sealing member on the first substrate or on the first electrode and placing the second substrate on the resultant to seal the elements, a gapping agent mixed in the sealing member makes the gaps of the sealing member uniform to the size of the gapping agent, making it easier to control the gaps of the sealing member.

The gapping agent is not particularly limited and may be appropriately selected depending on the intended purpose so long as the gapping agent has a particle shape and a uniform particle diameter, and has a high solvent resistance and a high heat resistance. As the gapping agent, a gapping agent that has a high affinity with an epoxy resin and has a spherical particle shape is preferable. Specifically, glass beads, silica particles, and organic resin particles are preferable. One of these gapping agents may be used alone or two or more of these gapping agents may be used in combination.

The particle diameter of the gapping agent may be selected depending on the gap of the sealing member to be set, and is preferably 1 micrometer or greater but 100 micrometers or less and more preferably 5 micrometers or greater but 50 micrometers or less.

The polymerization initiator is not particularly limited and may be appropriately selected depending on the intended purpose so long as the polymerization initiator initiates polymerization using heat or light. Examples of the polymerization initiator include a thermal polymerization initiator and a photopolymerization initiator.

The thermal polymerization initiator is a compound that generates active species such as radicals and cations in response to heating. Examples of the thermal polymerization initiator include azo compounds such as 2,2'-azobis butyronitrile (AIBN), and peroxides such as benzoyl peroxide (BPO). As a thermal cationic polymerization initiator, for example, benzene sulfonate and alkyl sulfonium salts are used.

On the other hand, as the photopolymerization initiator, a photo-cationic polymerization initiator is suitably used for an epoxy resin. When an epoxy resin mixed with a photo-cationic polymerization initiator is irradiated with light, the photo-cationic polymerization initiator decomposes and generates an acid, which initiates polymerization of the epoxy resin to undergo a curing reaction. The photo-cationic polymerization initiator has effects such as low volume shrinkage during curing, oxygen inhibition-free, and a high storage stability.

Examples of the photo-cationic polymerization initiator include aromatic diazonium salts, aromatic iodonium salts, aromatic sulfonium salts, metallocene compounds, and silanol-aluminum complexes.

As the polymerization initiator, a photoacid generator that has a function of generating an acid in response to light irradiation can also be used. The photoacid generator acts as an acid that initiates cationic polymerization. Examples of the photoacid generator include ionic onium salts such as sulfonium salts and iodonium salts that are formed of a cationic moiety and an anionic moiety. One of these photoacid generators may be used alone or two or more of these photoacid generators may be used in combination.

The amount of the polymerization initiator to be added may be different depending on the material used, but is preferably 0.5 parts by mass or greater but 10 parts by mass or less and more preferably 1 part by mass or greater but 5 parts by mass or less relative to the whole of the sealing member (100 parts by mass). When the amount of the polymerization initiator to be added is in the preferable range described above, curing can proceed appropriately, the materials that may remain uncured can be reduced, and an excessive outgas can be prevented.

The desiccant is also referred to as moisture absorbent, and is a material that has a function of physically or chemically adsorbing moisture to itself, or absorbing moisture. When the desiccant is added in the sealing member, moisture resistance can further be enhanced, and influence of an outgas can be reduced.

The desiccant is not particularly limited and may be appropriately selected depending on the intended purpose. A desiccant having a particle shape is preferable. Examples of the desiccant include inorganic moisture absorbent materials such as calcium oxide, barium oxide, magnesium oxide, magnesium sulfate, sodium sulfate, calcium chloride, silica gel, a molecular sieve, and zeolites. Among these desiccants, zeolites having a high moisture absorbing capacity are preferable. One of these desiccants may be used alone or two or more of these desiccants may be used in combination.

The curing accelerator is also referred to as curing catalyst, and is a material that increases the curing speed. The curing accelerator is mainly used for thermosetting epoxy resins.

The curing accelerator is not particularly limited and may be appropriately selected depending on the intended purpose. Examples of the curing accelerator include tertiary amines or tertiary amine salts such as DBU (1,8-diazabicyclo(5,4,0)-undecene-7) and DBN (1,5-diazabicyclo(4,3,0)-nonene-5), imidazoles such as 1-cyanoethyl-2-ethyl-4-methyl imidazole and 2-ethyl-4-methyl imidazole, and phosphines and phosphonium salts such as triphenyl phosphine and tetraphenyl phosphonium tetraphenyl borate. One of these curing accelerators may be used alone or two or more of these curing accelerators may be used in combination.

The coupling agent is not particularly limited and may be appropriately selected depending on the intended purpose so long as the coupling agent is a material having an effect of increasing a molecular binding power. Examples of the coupling agent include silane coupling agents. More specific examples of the silane coupling agents include 3-glycidoxypropyl trimethoxysilane, 3-glycidoxypropyl methyl dimethoxysilane, 3-glycidoxypropyl methyl dimethoxysilane, 2-(3,4-epoxycyclohexyl)ethyl trimethoxysilane, N-phenyl-γ-aminopropyl trimethoxysilane, N-(2-aminoethyl)3-aminopropyl methyl dimethoxysilane, N-(2-aminoethyl)3-aminopropyl methyl trimethoxysilane, 3-aminopropyl triethoxysilane, 3-mercaptopropyl trimethoxysilane, vinyl trimethoxysilane, N-(2-(vinylbenzylamino)ethyl)3-aminopropyl trimethoxysilane hydrochloride, and 3-methacryloxypropyl trimethoxysilane. One of these coupling agents may be used alone or two or more of these coupling agents may be used in combination.

As the sealing member, epoxy resin compositions commercially available as sealing materials, seal materials, or adhesives are known, and can be effectively used in the present disclosure. Particularly, there are epoxy resin compositions that are developed and sold for solar cells and organic EL elements. Such epoxy resin compositions can be particularly effectively used in the present disclosure. Examples of commercially available epoxy resin compositions include TB3118, TB3114, TB3124, and TB3125F (available from ThreeBond Holdings Co., Ltd.), WORLDROCK5910, WORLDROCK5920, and WORLDROCK8723 (available from Kyoritsu Chemical & Co., Ltd.), and WB90US(P) (available from MORESCO Corporation).

In the present disclosure, a sheet-shaped sealing material can be used as the sealing member.

A sheet-shaped sealing material is a product in which an epoxy resin layer is previously formed on a sheet. Glass, and films having a high gas barrier property are used as the sheet. By pasting a sheet-shaped sealing material on the second substrate, and subsequently curing the resultant, it is possible to simultaneously form the sealing member and the second substrate. Depending on the formation pattern of the epoxy resin layer to be formed on the sheet, it is possible to form the sealing member as a structure including a hollow portion.

The method for forming the sealing member is not particularly limited and may be appropriately selected depending on the intended purpose. Examples of the method include a dispenser method, a wire bar method, a spin coating method, a roller coating method, a blade coating method, and a gravure coating method. Moreover, as the method for forming the sealing member, for example, methods such as letterpress, offset printing, gravure printing, intaglio printing, rubber plate printing, and screen printing may also be employed.

Moreover, a passivation layer may be provided between the sealing member and the second electrode. The passivation layer is not particularly limited and may be appropriately selected depending on the intended purpose so long as the passivation layer is disposed in a manner that the sealing member does not contact the second electrode. Examples of the passivation layer include aluminum oxide, silicon nitride, and silicon oxide.

### <Other members>

The other members are not particularly limited and may be appropriately selected depending on the intended purpose.

An embodiment for carrying out the present disclosure will be described below with reference to the drawings. In the drawings, the same components will be denoted by the same reference numerals and may not be described redundantly.

### <Configuration of solar cell module>

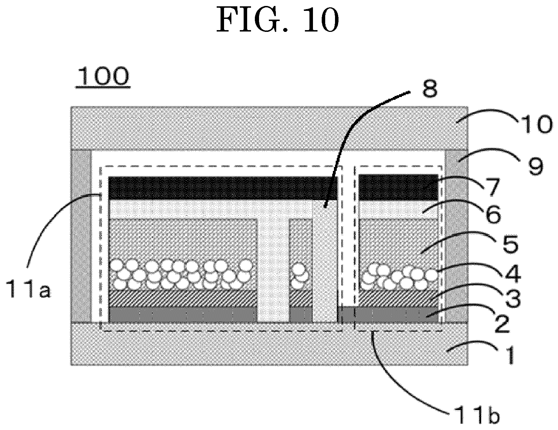

FIG. 10 is a cross-sectional view illustrating an example of a cross-sectional structure of a solar cell module of the present disclosure. As illustrated in FIG. 10, the solar cell module 100 includes a photoelectric conversion element 11a and a photoelectric conversion element 11b. Each of the photoelectric conversion element 11a and the photoelectric conversion element 11b is a photoelectric conversion element including on a first substrate 1, a first electrode 2, a dense layer 3, a porous electron transporting layer (porous layer) 4, a perovskite layer 5, a hole transporting layer 6, and a second electrode 7. The photoelectric conversion element 11a and the photoelectric conversion element 11b adjoin each other. The first electrodes are electrically coupled to each other. The electron transporting layers, the perovskite layers, and the hole transporting layers are each separated from each other by a gap. In at least one of the photoelectric conversion element 11a and the photoelectric conversion element 11b, the first electrode 2, the dense layer 3, the porous layer 4, and the perovskite layer 5 are divided by the hole transporting layer 6.

By the first electrode 2, the dense layer 3, the porous layer 4, and the perovskite layer 5 being divided by the hole transporting layer 6, the solar cell module 100 has fewer chances of electron recombination due to diffusion, and can maintain the power generation efficiency even through exposure to high-illuminance light for a long time. The first electrode 2 and the second electrode 7 have paths electrically continuous to electrode extraction terminals.

Moreover, in the solar cell module 100, a second substrate 10 is disposed counter to the first substrate 1 in a manner to sandwich the photoelectric conversion element described above, and a sealing member 9 is disposed between the first substrate 1 and the second substrate 10.

In the photoelectric conversion element 11a and the photoelectric conversion element 11b, the first electrodes are electrically coupled to each other, and the electron transporting layers, the perovskite layers, and the hole transporting layers are each separated from each other by a gap. The gap may be filled with a gas, or may be a vacuum.

The width of the gap is not particularly limited, may be appropriately selected depending on the intended purpose, and is preferably 0.03 mm or greater but 1 mm or less and more preferably 0.05 mm or greater but 0.2 mm or less.

The photoelectric conversion element of the solar cell module 100 is sealed by the first substrate 1, the sealing member 9, and the second substrate 10. Therefore, the amount of moisture and the oxygen concentration in the hollow portion present between the second electrode 7 and the second substrate 10 can be controlled. By controlling the amount of moisture and the oxygen concentration in the hollow portion of the solar cell module 100, it is possible to improve the power generation performance and durability. That is, when the solar cell module further includes the second substrate disposed counter to the first substrate in a manner to sandwich the photoelectric conversion element, and the sealing member disposed between the first substrate and the second substrate to seal the photoelectric conversion element, the amount of moisture and the oxygen concentration in the hollow portion can be controlled. As a result, the power generation performance and durability can be improved.

The oxygen concentration in the hollow portion is not particularly limited, may be appropriately selected depending on the intended purpose, and is preferably 0% or higher but 21% or lower, more preferably 0.05% or higher but 10% or lower, and yet more preferably 0.1% or higher but 5% or lower.

Moreover, because the second electrode 7 and the second substrate 10 do not contact each other in the solar cell module 100, peeling or breakage of the second electrode 7 can be prevented.

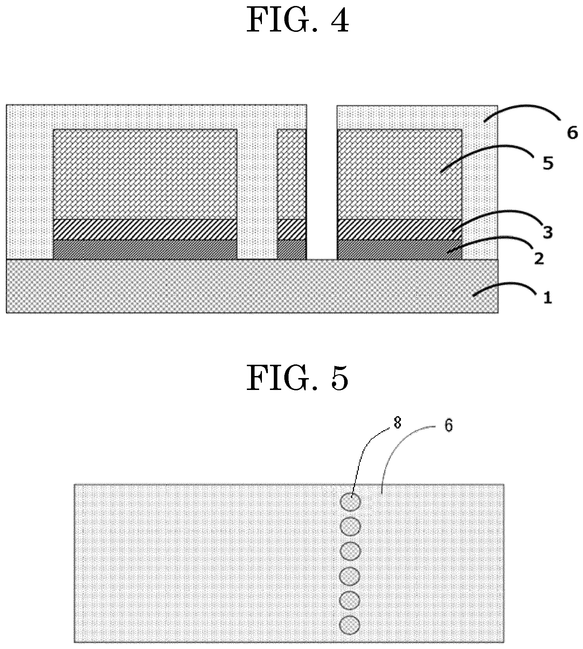

In the solar cell module 100, the photoelectric conversion element 11a and the photoelectric conversion element 11b are electrically coupled to each other. Specifically, the solar cell module 100 has a penetrating portion 8 that electrically couples the photoelectric conversion element 11a and the photoelectric conversion element 11b to each other. A plurality of penetrating portions 8 each having a circular shape (hereinafter, such a penetrating portion may be referred to as a through-hole) may be formed as illustrated in FIG. 5, or a penetrating portion 8 having a line shape may be formed all along one direction of a photoelectric conversion element.

By forming the second electrode after forming the penetrating portion 8, it is possible to form the material of the second electrode on the side surface of the penetrating portion 8 and electrically couple adjoining photoelectric conversion elements to each other. As the conductive material to be formed on the side surface of the penetrating portion 8, a material different from the material of the second electrode may also be used.

In the solar cell module 100, the photoelectric conversion element 11a and the photoelectric conversion element 11b are serially coupled to each other through electrical coupling of the second electrode 7 of the photoelectric conversion element 11a to the first electrode 2 of the photoelectric conversion element 11b through the penetrating portion 8 penetrating the hole transporting layer 6 in this way. It is possible to couple a plurality of photoelectric conversion elements in parallel. However, by coupling a plurality of photoelectric conversion elements serially, it is possible to increase the open circuit voltage of the solar cell module.

The penetrating portion 8 may reach the first substrate 1 by penetrating the first electrode 2, or may not reach the first substrate 1 by stop of machining within the first electrode 2. When shaping the penetrating portion 8 into a minute pore penetrating the first electrode 2 and reaching the first substrate 1, if the total of the opening area of the minute pore is extremely large relative to the area of the penetrating portion 8, the film cross-sectional area of the first electrode 2 is small. This may generate a high resistance, and degrade the photoelectric conversion efficiency. Therefore, the ratio of total of the opening area of the minute pore to the area of the penetrating portion 8 is preferably 5/100 or greater but 60/100 or less.

The method for forming the penetrating portion is not particularly limited and may be appropriately selected depending on the intended purpose. Examples of the method include a sandblasting method, a water blasting method, a chemical etching method, a laser machining method, and a method using polishing paper. Among these methods, the laser machining method that can form the penetrating portion 8 without using, for example, sand, etching, or a resist, and can hence machine the penetrating portion 8 cleanly with a good reproducibility is preferable. Another reason the laser machining method is preferable is that when the penetrating portion 8 is formed, at least one of the dense layer 3, the porous electron transporting layer (porous layer) 4, the perovskite layer 5, the hole transporting layer 6, and the second electrode 7 can be removed by impact peeling resulting from the laser machining method. As a result, there is no need for providing a mask during layer lamination, and it is possible to remove the materials constituting the photoelectric conversion element and form the penetrating portion simultaneously and easily.

In at least one of the photoelectric conversion element 11a and the photoelectric conversion element 11b, the first electrode 2, the dense layer 3, the porous layer 4, and the perovskite layer 5 are divided by the hole transporting layer 6. The width by which the first electrode 2, the dense layer 3, the porous layer 4, and the perovskite layer 5 are divided is preferably 50 micrometers or greater.

When the photoelectric conversion element 11a and the photoelectric conversion element 11b are not divided by the hole transporting layer and are affected by positive hole diffusion of the hole transporting layer, the photoelectric conversion element 11a and the photoelectric conversion element 11b leak charges. Hence, it is difficult to maintain the power generation efficiency through exposure to high-illuminance light for a long time. That is, when the dividing width of the hole transporting layer is 50 micrometers or greater, it is possible to maintain the power generation efficiency even through exposure to high-illuminance light for a long time.

The solar cell module of the present disclosure can be applied to a power supply device when the solar cell module of the present disclosure is combined with, for example, a circuit board configured to control a generated current. Examples of devices utilizing a power supply device include a desktop electronic calculator and a wristwatch. A power supply device including the photoelectric conversion element of the present disclosure can be applied to, for example, a portable phone, an electronic organizer, and electronic paper. Moreover, a power supply device including the photoelectric conversion element of the present disclosure can also be used as a power supply that can be used at, for example, night time when the power supply device including the photoelectric conversion element of the present disclosure is combined with, for example, an auxiliary power supply or a secondary battery for making the continuous use time of a rechargeable-type or dry-cell-type electric appliance long. Furthermore, a power supply device including the photoelectric conversion element of the present disclosure can also be used in, for example, an IoT device or an artificial satellite as a stand-alone power supply that needs no battery exchange or power supply wiring.

### Examples

The present disclosure will be described below by way of Examples and Comparative Examples. The present disclosure should not be construed as being limited to these Examples.

### (Example 1)

### <Production of solar cell module>

An indium tin oxide (ITO) glass substrate was used as a substrate and a first electrode.

A tin oxide colloid solution (obtained from Alfa Aesar Inc.) was applied on the ITO glass substrate and heated and dried at 100 degrees C for one hour. Next, a 0.1 mM (where M represents mol/dm³) solution obtained by dissolving (1-aminoethyl)phosphonic acid (obtained from Sigma-Aldrich, Inc.) in ethanol was applied on the film described above by a spin coating method, and dried at 70 degrees C for 10 minutes, to obtain an electron transporting layer.

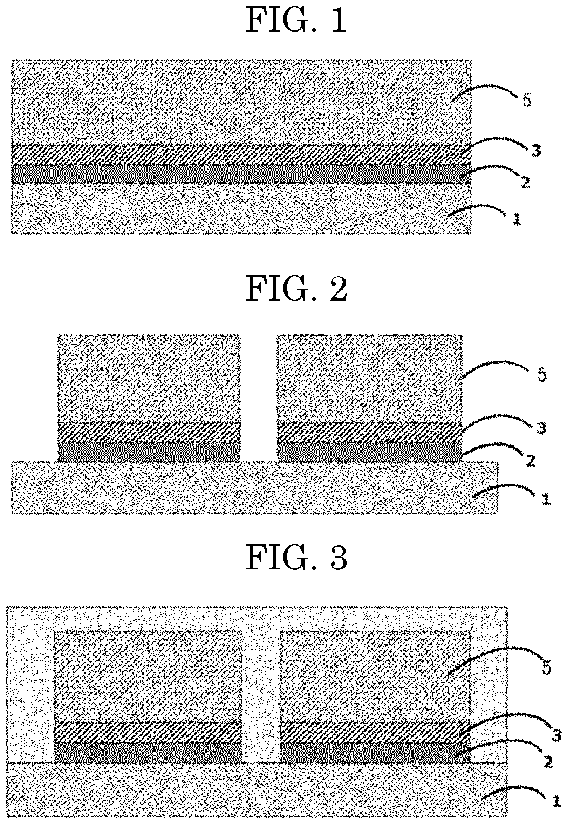

Next, lead (II) iodide (0.5306 g), lead (II) bromide (0.0736 g), methylamine bromide (0.0224 g), formamidine iodide (0.1876 g), and potassium iodide (0.0112 g) were added to N,N-dimethyl formamide (0.8 ml) and dimethyl sulfoxide (0.2 ml), and the resultant was heated at 60 degrees C and stirred, to obtain a solution. While the obtained solution was applied on the electron transporting layer described above by a spin coating method, chlorobenzene (0.3 ml) was added, to form a perovskite film, which was dried at 150 degrees C for 30 minutes, to produce a perovskite layer. The average thickness of the perovskite layer was adjusted to from 200 nm through 350 nm (FIG. 1).

A groove was formed in the laminate obtained through the steps described above by laser machining in a manner that the distance between adjoining laminates would be 10 micrometers (FIG. 2). Next, a polymer indicated by (A-5) (with a weight average molecular weight of 20,000 and an ionization potential of 5.22 eV) (36.8 mg), and as an additive, an additive indicated by (B-14) (7.4 mg) were weighed out, and dissolved in chlorobenzene (3.0 ml). The obtained solution was applied on the laminates obtained through the steps described above by a spin coating method, to produce a hole transporting layer. The average thickness of the hole transporting layer (the portion on the perovskite layer) was adjusted to from 50 nm through 120 nm (FIG. 3). Next, a pore (hereinafter, may be referred to as a through-hole) was formed by laser machining in a manner to penetrate all of the ITO (2) to the hole transporting layer (6). The cross-sectional view is illustrated in FIG. 4, and the top view is illustrated in FIG. 5.

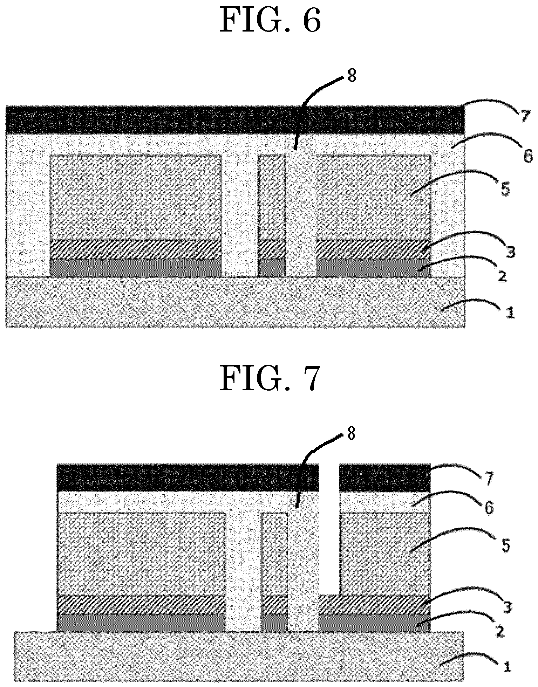

Gold was further deposited by 100 nm on the laminates by vacuum vapor deposition (FIG. 6).

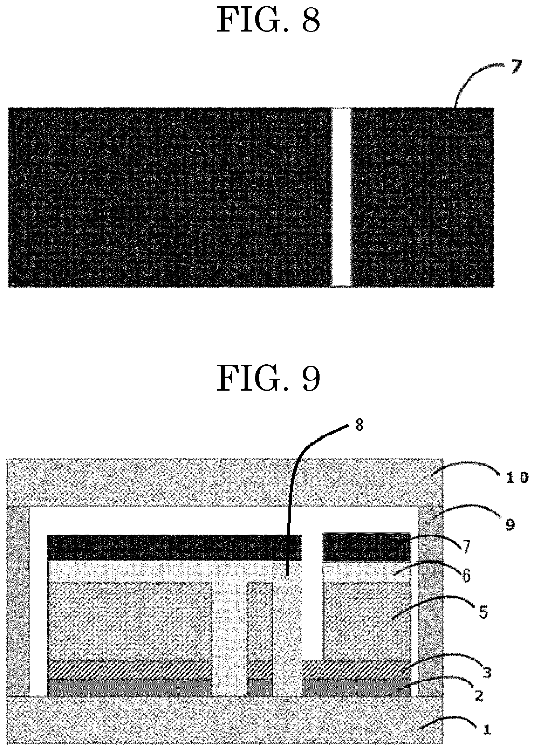

Subsequently, the end portions of the first substrate and the second substrate to be provided thereon with a sealing member, and the perovskite layer were etched by laser machining, and it was confirmed that the adjoining photoelectric conversion elements were serially coupled (the cross-sectional view is illustrated in FIG. 7, and the top view is illustrated in FIG. 8). The number of photoelectric conversion elements serially coupled was two.

Next, using a dispenser (obtained from San-Ei Tech Ltd., product name: 2300N), an ultraviolet-curable resin (obtained from ThreeBond Holdings Co., Ltd., product name: TB3118) was applied on the end portions of the first substrate in a manner that the photoelectric conversion elements (power generation regions) would be surrounded by the ultraviolet-curable resin. Subsequently, the resultant was removed into a glovebox controlled to a low humidity (a dew point of -30 degrees C) and to an oxygen concentration of 0.2%, a cover glass serving as a second substrate was placed on the ultraviolet-curable resin, and the ultraviolet-curable resin was cured by ultraviolet irradiation to seal the power generation regions, to produce a solar cell module 1 in which two cells were serially coupled as illustrated in FIG. 10.

### <Evaluation of solar cell module>

Under light irradiation using a solar simulator (AM1.5, 100 mW/cm²), the solar cell properties (initial properties) of the obtained solar cell module 1 were evaluated with a solar cell evaluation system (obtained from NF Corporation, product name: AS-510-PV03). Moreover, after continuous light irradiation for 500 hours using the solar simulator described above under the same conditions as described above, the solar cell properties (properties after continuous irradiation for 500 hours) were evaluated in the same manner as described above.

The solar cell properties evaluated were an open circuit voltage, a short circuiting current density, a form factor, and a conversion efficiency (power generation efficiency). Moreover, the ratio of the conversion efficiency under the properties after continuous irradiation for 500 hours to the conversion efficiency under the initial properties was obtained as a conversion efficiency maintaining ratio. The results are presented in Table 1.

### (Example 2)

A solar cell module was produced in the same manner as in Example 1, except that unlike in Example 1, the polymer indicated by (A-5) (36.8 mg) and the additive (B-14) (7.4 mg) were changed to poly(3-n-hexylthiophene) (36.8 mg), lithium bis(trifluoromethyl sulfonylimide) (4.8 mg), and 4-t-butyl pyridine (6.8 mg). The properties of the obtained solar cell module were evaluated. The results are presented in Table 1.

### (Example 3)

A solar cell module was produced in the same manner as in Example 1, except that unlike in Example 1, "lead (II) iodide (0.5306 g), lead (II) bromide (0.0736 g), methylamine bromide (0.0224 g), formamidine iodide (0.1876 g), and potassium iodide (0.0112 g) were added to N,N-dimethyl formamide (0.8 ml) and dimethyl sulfoxide (0.2 ml)" was changed to --lead (II) iodide (0.4841 g), antimony (III) iodide (0.0502 g), lead (II) bromide (0.0736 g), methylamine bromide (0.0224 g), formamidine iodide (0.1876 g), and potassium iodide (0.0112 g) were added to N,N-dimethyl formamide (0.8 ml) and dimethyl sulfoxide (0.2 ml)- -. The properties of the obtained solar cell module were evaluated. The results are presented in Table 1.

### (Example 4)

A solar cell module was produced in the same manner as in Example 1, except that unlike in Example 1, after a tin oxide colloid solution (obtained from Alfa Aesar Inc.) was applied on an ITO glass substrate and heated and dried at 100 degrees C for 1 hour, a solution obtained by diluting PECC-B01 obtained from Pexel Technologies Co., Ltd. tenfold with ethanol was applied using a spin coater, to form a porous TiO₂ layer. The properties of the obtained solar cell module were evaluated. The results are presented in Table 1. The cross-sectional view of the device is illustrated in FIG. 10.

### (Comparative Example 1)

A solar cell module was produced in the same manner as in Example 1, except that unlike in Example 1, the hole transporting layer was formed in a manner not to separate the first electrode, the electron transporting layer, and the perovskite layer. The properties of the obtained solar cell module were evaluated. The results are presented in Table 2.

### (Comparative Example 2)

A solar cell module was produced in the same manner as in Example 1, except that unlike in Example 1, the second electrode was formed in a manner not to separate the first electrode, the electron transporting layer, the perovskite layer, and the hole transporting layer. The properties of the obtained solar cell module were evaluated. The results are presented in Table 2.

### (Comparative Example 3)

A solar cell module was produced in the same manner as in Example 1, except that unlike in Example 1, the perovskite layer was free of a perovskite compound. The properties of the obtained solar cell module were evaluated. The results are presented in Table 2.

**Table 1**

| | Initial | | | | After continuous irradiation for 500 hours | | | | Photo-electric conversion ratio maintaining ratio (%) |
|---|---|---|---|---|---|---|---|---|---|
| | Open circuit voltage (V) | Short circuiting current density (mA/cm²) | Form factor | Conversion efficiency (%) | Open circuit voltage (V) | Short circuiting current density (mA/cm²) | Form factor | Conversion efficiency (%) | |
| Ex. 1 | 2.11 | 10.2 | 0.7 | 15.1 | 2.09 | 10.2 | 0.69 | 14.7 | 97.4 |
| Ex. 2 | 2.07 | 10.6 | 0.71 | 15.6 | 1.99 | 10.1 | 0.69 | 13.9 | 89.1 |
| Ex. 3 | 2.08 | 11.3 | 0.69 | 16.2 | 2.05 | 11.2 | 0.69 | 15.8 | 97.5 |
| Ex. 4 | 2.23 | 11.2 | 0.7 | 17.5 | 2.18 | 10.7 | 0.67 | 15.6 | 89.1 |

**Table 2**

| | Initial | | | | After continuous irradiation for 500 hours | | | | Photo-electric conversion ratio maintaining ratio (%) |
|---|---|---|---|---|---|---|---|---|---|
| | Open circuit voltage (V) | Short circuiting current density (mA/cm²) | Form factor | Conversion efficiency (%) | Open circuit voltage (V) | Short circuiting current density (mA/cm²) | Form factor | Conversion efficiency (%) | |
| Comp. Ex. 1 | 1.92 | 9.5 | 0.7 | 12.8 | 1.8 | 8.9 | 0.63 | 10.1 | 78.9 |
| Comp. Ex. 2 | 1.8 | 10.2 | 0.72 | 13.2 | 1.79 | 9 | 0.61 | 9.8 | 74.2 |
| Comp. Ex. 3 | 1.89 | 9.3 | 0.68 | 11.9 | 1.78 | 8.8 | 0.61 | 9.5 | 79.8 |

From the results of Table 1, it can be seen that not only did Examples 1 to 4 have very good initial properties, but also all of Examples 1 to 4 had a conversion efficiency maintaining ratio of 80% or higher after the continuous irradiation test for 500 hours, meaning that the solar cell modules had a good durability. On the other hand, it was obvious that Comparative Example 1 had a low conversion efficiency maintaining ratio after the continuous irradiation test for 500 hours.

As described above, in the solar cell module of the present disclosure, the electron transporting layers and the perovskite layers of at least two photoelectric conversion elements adjoining each other are separated by the hole transporting layer. As a result, the solar cell module of the present disclosure can maintain the power generation efficiency even through exposure to high-illuminance light for a long time.

Aspects of the present disclosure are, for example, as follows.
<1> A solar cell module, including:
   a substrate; and
   a plurality of photoelectric conversion elements provided on the substrate and each including a first electrode, an electron transporting layer, a perovskite layer, a hole transporting layer, and a second electrode,
   wherein in adjoining two of the photoelectric conversion elements, the first electrodes are electrically coupled to each other, and the electron transporting layers, the perovskite layers, and the hole transporting layers are each separated from each other by a gap,
   the second electrode of one of the photoelectric conversion elements and the first electrode of the other of the photoelectric conversion elements are electrically coupled to each other, and
   the first electrode, the electron transporting layer, and the perovskite layer in the one of the photoelectric conversion elements are divided by the hole transporting layer.
<2> The solar cell module according to <1>,
   the photoelectric conversion elements contain a compound represented by General formula (1) below,

      XαYβZγ --- General formula (1)
   where in the General formula (1), a ratio α:β:γ is 3:1:1, β and γ represent integers greater than 1, X represents a halogen atom, Y represents an organic compound containing an amino group, and Z represents a metal ion.
<3> The solar cell module according to <1> or <2>,
   wherein the hole transporting layer contains a compound represented by General formula (2) below or a compound represented by General formula (3) below, or both, 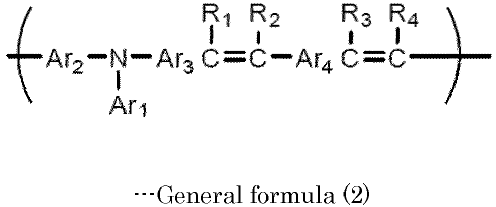
   wherein in the General formula (2), Ar₁ represents a substituted or unsubstituted aromatic hydrocarbon group, Ar₂ and Ar₃ each independently represent a substituted or unsubstituted monocyclic, uncondensed polycyclic, or condensed polycyclic divalent aromatic hydrocarbon group, and Ar₄ represents a divalent benzene, thiophene, biphenyl, anthracene, or naphthalene group that may contain a substituent, 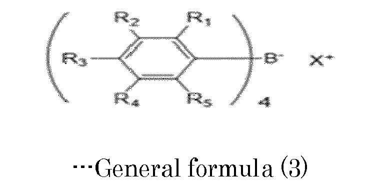
   where in the General formula (3), R₁ to R₅ represent a hydrogen atom, a halogen atom, an alkyl group, or an alkoxy group, and may be same as or different from one another, and X represents a cation.
<4> The solar cell module according to any one of <1> to <3>,
   wherein the perovskite layer contains at least one selected from the group consisting of a Sb atom, a Cs atom, a Rb atom, and a K atom.
<5> The solar cell module according to any one of <1> to <4>, further comprising
   an amine compound between the perovskite layer and the hole transporting layer.
<6> The solar cell module according to any one of <1> to <5>,
   wherein the electron transporting layer contains at least tin oxide.
<7> The solar cell module according to any one of <1> to <6>,
   wherein the electron transporting layer includes a dense layer.
<8> The solar cell module according to any one of <1> to <7>,
   wherein the photoelectric conversion elements are coupled serially or in parallel.

The solar cell module according to any one of <1> to <8> can solve the various problems in the related art and achieve the object of the present disclosure.

## Claims

1. A solar cell module, comprising:
a substrate; and
a plurality of photoelectric conversion elements provided on the substrate and each including a first electrode, an electron transporting layer, a perovskite layer, a hole transporting layer, and a second electrode,
wherein in adjoining two of the photoelectric conversion elements, the first electrodes are electrically coupled to each other, and the electron transporting layers, the perovskite layers, and the hole transporting layers are each separated from each other by a gap,
the second electrode of one of the photoelectric conversion elements and the first electrode of the other of the photoelectric conversion elements are electrically coupled to each other, and
the first electrode, the electron transporting layer, and the perovskite layer in the one of the photoelectric conversion elements are divided by the hole transporting layer.

2. The solar cell module according to claim 1,
the photoelectric conversion elements contain a compound represented by General formula (1) below,
XαYβZγ --- General formula (1)
where in the General formula (1), a ratio α:β:γ is 3:1:1, β and γ represent integers greater than 1, X represents a halogen atom, Y represents an organic compound containing an amino group, and Z represents a metal ion.

3. The solar cell module according to claim 1 or 2,
wherein the hole transporting layer contains a compound represented by General formula (2) below or a compound represented by General formula (3) below, or both, 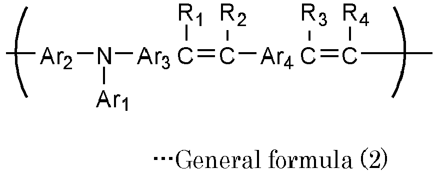
wherein in the General formula (2), Ar₁ represents a substituted or unsubstituted aromatic hydrocarbon group, Ar₂ and Ar₃ each independently represent a substituted or unsubstituted monocyclic, uncondensed polycyclic, or condensed polycyclic divalent aromatic hydrocarbon group, and Ar₄ represents a divalent benzene, thiophene, biphenyl, anthracene, or naphthalene group that may contain a substituent, 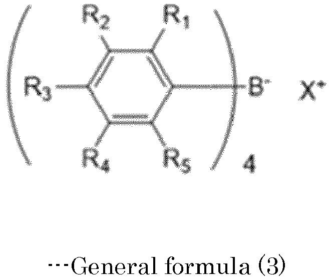
where in the General formula (3), R₁ to R₅ represent a hydrogen atom, a halogen atom, an alkyl group, or an alkoxy group, and may be same as or different from one another, and X represents a cation.

4. The solar cell module according to any one of claims 1 to 3,
wherein the perovskite layer contains at least one selected from the group consisting of a Sb atom, a Cs atom, a Rb atom, and a K atom.

5. The solar cell module according to any one of claim 1 to 4, further comprising
an amine compound between the perovskite layer and the hole transporting layer.

6. The solar cell module according to any one of claims 1 to 5,
wherein the electron transporting layer contains at least tin oxide.

7. The solar cell module according to any one of claims 1 to 6,
wherein the electron transporting layer includes a dense layer.

8. The solar cell module according to any one of claims 1 to 7,
wherein the photoelectric conversion elements are coupled serially or in parallel.
